# EUROPEAN PATENT APPLICATION

(11) **EP 1 601 008 A1**
(43) Date of publication of application: **30.11.2005**
(21) Application number: 04717274.7
(22) Date of filing: 04.03.2004
(51) Int. Cl.: H01L 21/027, G03F 7/038, G03F 7/20

(54) **IMMERSION LIQUID FOR IMMERSION EXPOSURE PROCESS AND RESIST PATTERN FORMING METHOD USING SUCH IMMERSION LIQUID**

(30) Priority: 04.03.2003 JP 2003057608; 09.05.2003 JP 2003132289; 25.08.2003 JP 2003300665; 17.02.2004 JP 2004039772
(71) Applicant: TOKYO OHKA KOGYO CO., LTD., Kawasaki-shi Kanagawa 211-0012 (JP)
(72) Inventor: HIRAYAMA, TakuC/o Tokyo Ohka Kogyo Co., Ltd., Kawasaki-shi, Kanagawa 2110012 (JP); SATO, Mitsuru, C/o Tokyo Ohka Kogyo Co., Ltd., Kawasaki-shi, Kanagawa 2110012 (JP); WAKIYA, Kazumasa, c/o Tokyo Ohka Kogyo Co., Ltd., Kawasaki-shi, Kanagawa 2110012 (JP); IWASHITA, Jyun, c/o Tokyo Ohka Kogyo Co., Ltd., Kawasaki-shi, Kanagawa 2110012 (JP); YOSHIDA, Masaaki, c/o Tokyo Ohka Kogyo Co., Ltd., Kawasaki-shi, Kanagawa 2110012 (JP)
(74) Representative: HOFFMANN EITLE
(86) International application number: PCT/JP2004/002747
(87) International publication number: WO 2004/079800

(57) **Abstract**

An immersion fluid for use in liquid immersion lithography in which a resist film is exposed to light via a fluid. The fluid is transparent to the exposure light used in the liquid immersion lithography and comprises a fluorine-based liquid having a boiling point of 70 to 270 °C. A method of forming resist patter includes a step of placing the immersion fluid directly on the resist film or a protective film deposited on the resist film. The present invention prevents alteration of resist film and other films as well as alteration of the fluid during liquid immersion lithography and enables high resolution resist patterning using liquid immersion lithography.

## Description

### TECHNICAL FIELD

The present invention relates to a fluid (referred to as immersion fluid, hereinafter) suitable for use in liquid immersion lithography, in particular, a type of liquid immersion lithography in which a predetermined thickness of fluid having a higher refractive index than that of air is placed at least on a resist film in the path of the exposure light irradiated onto the resist film to expose the resist film, thereby increasing the resolution of the resist pattern. The present invention also relates to a method of forming a resist pattern using such an immersion fluid.

### BACKGROUND ART

Lithography is a technique commonly used to form fine structure on semiconductor devices, liquid crystal devices, and various other electronic devices. Finer resist patterns are required in the lithographic process as the structures of these devices have become even finer.

Although today's most advanced lithography technique can form resist patterns with a line width as narrow as 90 nm, it is expected that even finer patterns will be required in the near future.

A first key factor in achieving formation of 90 nm or finer patterns is a development of high precision lithography systems and resist materials for use with such systems. In many lithography systems, developments are generally made to decrease the wavelength of light sources, such as F2 laser, extreme Ultraviolet (EUV), electron beam, and X-ray, or to increase the numerical aperture (NA) of lenses.

However, decreasing the wavelength of light sources requires a new expensive lithography system, and the approach to increase NA is associated with the problem that a resolution trades off with a focal depth, namely an increase in the resolution generally leads to a decrease in the focal depth.

To address these problems, liquid immersion lithography has recently been developed as a new lithography technology (See, J.Vac.Sci.Technol.B (1999) 17(6) p3306-3309 (non-patent article 1); J.Vac.Sci.Technol.B (2001) 19(6) p2353-2356 (non-patent article 2); and Proceedings of SPIE Vol.4691 (2002) 4691 p459-465) (non-patent article 3)). In this technique, a predetermined thickness of a liquid, such as pure water and fluorine-based inert liquid (immersion fluid), is placed between a lens and a resist film on a substrate during exposure. The immersion fluid is placed at least over the resist film. In this technique, the immersion fluid, such as water, has a relatively large refractive index (n) and replaces air or inert gas, such as nitrogen, that has previously been used to fill the space through which the light passes. As a result, similar advantages to the short wavelength light sources and high NA lenses can be obtained by using the light source of the same wavelength and at the same time high resolution is achieved without decreasing the focal depth.

Thus, the liquid immersion lithography, allowing resist patterning with low cost, high resolution and good focal depth by using lenses mounted on existing apparatuses, has attracted significant attention.

### DISCLOSURE OF THE INVENTION

Inert water, such as pure water and deionized water, and perfluoroether have been proposed as immersion fluids for use in the liquid immersion lithography. Inert water is considered particularly useful because of its cost efficiency and easy handling. Since the resist film is contacted with immersion fluids during exposure and may be eroded, conventional resist compositions need to be tested to inspect whether they can be used in the liquid immersion lithography or not.

An essential property of resist compositions is transparency to the exposure light. Currently used resist compositions have been established through extensive searches for resins that meet this requirement. The present inventors have conducted experiments in an effort to obtain resist compositions suitable for use in liquid immersion lithography and to determine if conventional resist compositions can be used in liquid immersion lithography with or without slight modification. As a result, some resist compositions proved to be suitable for use in liquid immersion lithography, but many others were susceptible to change due to exposure to the fluid and could provide only a decreased pattern resolution. Even that the compositions provide only a decreased pattern resolution, such compositions gave high resolution when used in a common lithography where the exposure light transmits through an air layer. Any of these resist compositions has various favorable resist properties, including transparency to the exposure light, developability and storage stability, and has been developed by expending on significant development resources. The only disadvantage of these resist composition is the lack of resistance to immersion fluids.

Even for resist films intended for use with liquid immersion lithography, the quality and yield of nondefective products have proven to be lower when the compositions are used in liquid immersion lithography than in common lithography where the resist films are exposed via an air layer.

To evaluate the aforementioned requirements of conventional resist films for the liquid immersion lithography, the following analysis is conducted.

Specifically, the following three factors are considered in evaluating the performance of liquid immersion lithography to form resist patterns: (i) the performance of optical system used in the liquid immersion lithography; (ii) the effectof the resist film to the immersion fluid; and (iii) the alteration of the resist film due to the immersion fluid. Analysis of these factors is satisfactory to confirm the usefulness of the resist films.

Regarding the optical system (i), as can be understood from an experiment in which a water-resistant photographic photosensitive plate is submerged in water and a patterned light is irradiated onto the surface of the plate, the performance of the optical system (i) is sufficient, in principle, as long as the propagating light is not lost at the water surface and at the interface between water and the plate surface, for example, by reflection. The loss of the propagating light can be easily avoided by optimizing the incident angle of the exposure light. Thus, a subject to be exposed - whether it is a resist film, photographic sensitive plate or imaging screen - does not have any influence on the performance of the optical system, as long as the subject to be exposed is inert to the immersion fluid, namely, the subject to be exposed does not affect the immersion fluid, nor affected by the immersion fluid. Therefore, it does not require any experimentation to prove it.

The effect of the resist film (ii) on the immersion fluid specifically means a phenomenon in which the components of the resist film are dissolved into the immersion fluid to change the refractive index of the liquid. It is theoretically obvious that the change in the refractive index of the liquid affects the optical resolution of the pattern exposure. Therefore, no experiment is required to prove it and it is sufficient to confirm that the components of the immersed resist film have dissolved into the liquid to change its composition or refractive index. It is therefore not necessary to actually irradiate the patterning light to develop the pattern and thereby confirm the resolution.

Conversely, irradiating the patterning light onto the immersed resist film and developing the pattern to confirm the resolution may confirm the state of the resolution but cannot determine whether the effect on the resolution is caused by alteration of the immersion fluid or by alteration of the resist material or both.

The alteration of the resist film (iii) due to the immersion fluid results in a decreased resolution. This can be evaluated by sprinkling the immersion fluid onto the exposed resist film, subsequently developing the resist film and examining the resolution of the resulting resist pattern. Since this method involves directly sprinkling the liquid onto the resist film, the condition for liquid immersion becomes more harsh. When this test is conducted by exposing a completely immersed resist film, it becomes difficult to determine whether the change in the resolution has been caused by the alteration of the immersion fluid or by the alteration of the resist composition caused by the immersion fluid, or both.

The phenomena (ii) and (iii) are inextricably linked one another and can be evaluated by determining the degree of alteration of the resist film caused by the liquid.

Based on these analyses, the above-described conventional resist films were evaluated for their aptitude for liquid immersion lithography by sprinkling an immersion fluid (pure water) onto the exposed resist films , developing the films and examining the resolution of the resulting resist patterns (referred to as Evaluation Test 1, hereinafter). Also, actual production process was simulated by using the two-beam interference exposure method. Specifically, interference light generated by a prism to serve as a substitute light beam for patterning was irradiated onto immersed samples for exposure (referred to as Evaluation Test 2, hereinafter). Furthermore, the relationship between resist film and immersion fluid was evaluated by using the quartz oscillator method, a technique for measuring extremely small changes in the film thickness (the technique detects film thickness based on the weight change as measured by a quartz crystal microbalance) (referred to as Evaluation Test 3, hereinafter).

As mentioned above, the development of new resist films suitable for use in liquid immersion lithography should require significant manpower and development resources. Through the above-described analysis, however, it has been demonstrated that some of the conventional resist compositions can be directly used in the liquid immersion lithography with or without slight modification, although their quality may deteriorate to some degree. It has also been demonstrated that many resist films are susceptible to alteration and fail to provide sufficient pattern resolution when exposed to an immersion fluid (pure water) in liquid immersion lithography, and such resist films can still be used in common air layer-based lithography to form fine patterns with high resolution.

In view of the aforementioned drawbacks of the prior art, it is an objective of the present invention to provide a technique that allows the use of resist films made of conventional resist compositions, which have been developed at the cost of significant manpower and resources, in liquid immersion lithography. Specifically, the technique provided in accordance with the present invention employs, as the immersion fluid, a water-free liquid that is transparent to the exposure light, little evaporates under temperature conditions used during exposure, and is readily removed from the exposed resist film. According to the technique of the present invention, high resolution resist patterning using liquid immersion lithography is made possible. In addition, the resist films during liquid immersion lithography are prevented from altering and the used liquids themselves are simultaneously prevented from altering.

To achieve the above-described objective, an immersion fluid for use in liquid immersion lithography in accordance with the present invention is characterized by being transparent to the exposure light used in the liquid immersion lithography and comprising a fluorine-based solvent having a boiling point of 70 to 270 °C.

A method of forming resist pattern using liquid immersion lithography according to the present invention comprises the steps of:
forming at least a photoresist film on a substrate;
directly placing an immersion fluid on the resist film, the immersion fluid comprising a fluorine-based liquid being transparent to the exposure light used in the liquid immersion lithography and having a boiling point of 70 to 270 °C;
selectively exposing the resist film via the immersion fluid;
optionally heating the resist film; and
developing the resist film to form a resist pattern.

A second method of forming resist pattern using liquid immersion lithography according to the present invention comprises the steps of:
forming at least a photoresist film on a substrate;
forming a protective film on the resist film;
directly placing an immersion fluid on the protective film, the immersion fluid being transparent to the exposure light used in the liquid immersion lithography and comprising a fluorine-based liquid having a boiling point of 70 to 270 °C;
selectively exposing the resist film via the immersion fluid and the protective film;
optionally heating the resist film; and
developing the resist film to form a resist pattern.

In a particularly preferred construction of the liquid immersion lithography for use in the present invention, a predetermined thickness of the immersion fluid, which has a higher refractive index than that of air, is placed in the path of the lithography exposure light and at least on the resist film. In this manner, the exposed resist pattern has an improved resolution.

The present invention enables the use of any of the conventional resist compositions in forming a resist film suitable to make high precision resist patterns. The resist patterns produced according to the present invention are free of defects, such as T-shaped top profile, rough resist patternsurfaces,pattern fluctuation, and string formation, are highly sensitive, and have a superb resist pattern profile. According to the present invention, favorable resist patterning is achieved in cases where a protective film is formed on the resist film and the immersion film of the present invention is placed on the protective film.

Thus, the immersion filmof the present invention enables effective resist patterning by using liquid immersion lithography.

### BRIEF DESCRIPTION OF THE DRAWINGS

Fig. 1 is a graph showing variation of the film thickness of a resist film with respect to the immersion time.
Fig. 2 is a graph showing variation of the film thickness of a resist film with respect to the immersion time.

### BEST MODE FOR CARRYING OUT THE INVENTION

As described above, the immersion fluid according to the present invention comprises a fluorine-based liquid that is transparent to the exposure light used in the liquid immersion lithography and has a boiling point of 70 to 270 °C.

The immersion fluid comprising such fluorine-based liquid offers the following advantages: (i) the immersion fluid is inert to resist films formed of any of conventional resist compositions and does not change in quality of the resist films; (ii) the immersion fluid does not dissolve components of the resist film, so that its composition and refractive index to the exposure light are kept constant before and after exposure, providing stable light path; (iii) the immersion fluid has a boiling point of 70 °C or above, so that variation of composition of the immersion fluid due to evaporation, as well as variation of liquid level, is avoided during the exposure carried out at near room temperature, thereby ensuring stable and favorable light path; and (iv) the immersion fluid has a boiling of 270 °C or below, so that upon completion of the liquid immersion lithography, the immersion fluid can be completely removed from the resist film using simple techniques, such as drying at room temperature, spin drying, heat drying, and nitrogen blowing. Furthermore, the immersion fluid can dissolve significant amounts of oxygen, nitrogen, and other gases, so that the generation of microbubbles and nanobubbles can be effectively suppressed.

The fluorine-based liquids for use in the immersion fluid of the present invention have a boiling point preferably in the range of 70 to 270 °C and, more preferably, in the range of 80 to 220 °C. Specific examples of such fluorine-based liquids include perfluoroalkyl compounds,including perfluoroalkylether compounds and perfluoroalkyl amine compounds.

Examples of the perfluoroalkyl ether compound include perfluoroalkyl cyclic ethers, such as perfluoro(2-butyl-tetrahydrofuran) (bp = 102 °C). Examples of the perfluoroalkyl amine compound include perfluorotripropylamine N(C₃F₇)₃ (bp = 130 °C), perfluorotributylamine N(C₄F₉)₃ (bp = 174 °C), perfluorotripentylamine N(C₅F₁₁)₃ (bp = 215 °C) and perfluorotrihexylamine N(C₆F₁₃)₃ (bp = approx. 255 °C). Among them, the fluorine-based liquid containing concentrated hydrogen to a concentration of 10 ppm or below is preferably, because, the dissolving or swelling of the resist film is minimized, and the seeping out of various components from the resist film is also minimized.

Preferably, the fluorine-based liquid hardly absorbs the exposure light and has a volatility suitable for use as the immersion fluid. Examples of such a fluorine-based liquid include perfluorotripropylamine and perfluorotributylamine.

The aforementioned non-patent article, which is a relevant article of liquid immersion lithography, proposes the use of perfluoroalkyl polyether as an immersion fluid. In the course of our study to accomplish this invention, the present inventors examined the practicality of commercially available perfluoroalkyl polyether products as immersion fluids in terms of ease of development. As a result, it was proven that none of these products had a boiling point of 270 °C or below, which was one of the requirements for immersion fluids as described by the present inventors. For this reason, these products, when used as an immersion fluid, cannot be effectively removed after exposure of the resist film by using any of the above-described simple techniques. The residue of the immersion fluid then interferes with formation of the resist pattern.

In addition, these perfluoroalkyl polyethers have a large variance of their molecular weight. This may affect stable refractive index to the exposure light and, thus, the optical stability of exposure conditions.

The immersion fluid of the present invention, on the other hand, has a relatively small variance of its molecular weight and is thus considered suitable since the optical stability is not affected.

Any resist film formed of any of conventional resist compositions can be used as the resist film for use in the present invention. This is the most notable feature of the present invention.

As described above, the resist composition for use in the immersion liquid lithography of the present invention may be any resist composition used to make positive type photoresists or negative type photoresists. Specific examples of such a resist composition will now be described.

The base polymer (resin component) for use in positive type photoresist compositions may be an acrylic resin, cycloolefin resin, silsesquioxane resin, or fluorine-containing polymer.

The acrylic resin contains structural units (a1) derived from a (meth) acrylate having a functional group that dissociates in an acidic environment and serves to keep the resin from dissolving. The resin typically contains the structural units (a1) and other (meth)acrylate-derived structural units in an amount of 80 mol % or more, preferably 90 mol %, and most preferably 100 mol %.

To ensure resolution, resistance to dry etching, and fine pattern formation, the resin component comprises different monomer units other than the units (a1) with different functions. For example, the resin comprises a combination of the following structural units.

Namely, the resin comprises a combination of structural units derived from a (meth) acrylate having lactone units (referred to as unit (a2) or (a2), hereinafter); structural units derived from a (meth)acrylate having an alcoholic hydroxyl group-containing polycyclic group (referred to as unit (a3) or (a3), hereinafter) ; and structural units containing a polycyclic group that differs from any of the acid-dissociative anti-dissolving group of the unit (a1), the lactone unit of the unit (a2) and the alcoholic hydroxyl group-containing polycyclic group of the unit (a3) (referred to as unit (a4) or (a4), hereinafter).

Units (a2), (a3), and/or (a4) are used in a.proper combination depending on the required properties. Good resolution as well as resist patterning can be ensured if the resin contains (a1) along with at least one selected from (a2), (a3), and (a4). Each of (a1) through (a4) may comprise a plurality of different types of units.

The structural units derived frommethacrylate and the structural units derived from acrylate are used in amounts of from 10 to 85 mol % and from 15 to 90 mol %, respectively, and preferably in amounts of from 20 to 80 mol % and from 20 to 80 mol %, respectively, with respect to the total number of mols of the methacrylate-derived structural units and the acrylate-derived structural units.

The units (a1) through (a4) will now be described in further detail.

The unit (a1) is a structural unit derived from (meth)acrylate having a functional group that dissociates in an acidic environment and serves to keep the resin from dissolving. This acid-dissociative anti-dissolving group of the unit (a1) may be any functional group that serves to keep the entire resin components from dissolving in an alkali solution prior to exposure and, following exposure, dissociates as it is acted upon by an acid generated during exposure, making the resin components dissolvable in an alkali solution. Among widely known such functional groups include functional groups that can form cyclic or chain-like tertiary alkyl esters with carboxyl groups of (meth) acrylic acids, tertiary alkoxycarbonyl groups, and chain-like alkoxyalkyl groups.

One preferred example of the acid-dissociative anti-dissolving group of the unit (a1) is an acid-dissociative anti-dissolving group containing an aliphatic polycyclic group.

Examples of such polycyclic groups include bicycloalkane, tricycloalkane, and teroracycloalkane that may or may not be substituted with a fluorine atom or a fluorinated alkyl group and from which single hydrogen atom has been removed. Specific examples are polycycloalkanes, such as adamantane, norbornane, isobornane, tricyclodecane, and tetracyclododecane, from which single hydrogen atom has been removed. Such polycyclic groups may be properly selected from many of those proposed for use with ArF resists. Of these, adamantyl group, norbornyl group, and tetracyclododecanyl group are industrially preferred.

Preferred monomer units for use as the unit (a1) are shown by the following general formulae (1) through (7). In the general formulae (1) through (7), R is hydrogen or methyl group, R₁ is lower alkyl group, R₂ and R₃ are each independently lower alkyl group, R₄ is tertiary alkyl group, R₅ is methyl group, and R₆ is lower alkyl group.

Preferably, R₁ through R₃ and R₆ are each a straight-chained or branched lower alkyl group having 1 to 5 carbon atoms, such as methyl group, ethyl group, propyl group, isopropyl group, n-butyl group, isobutyl group, tert-butyl group, pentyl group, isopentyl group, and neopentyl group. Methyl and ethyl groups are industrially preferred.

R₄ is tertiary alkyl group such as tert-butyl group and tert-amyl group. Tert-butyl group is industrially preferred.

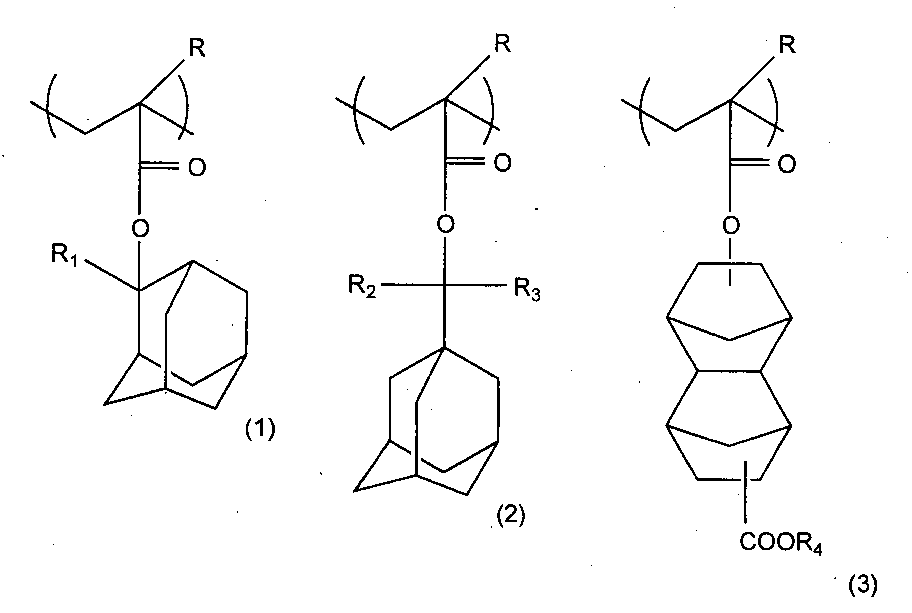

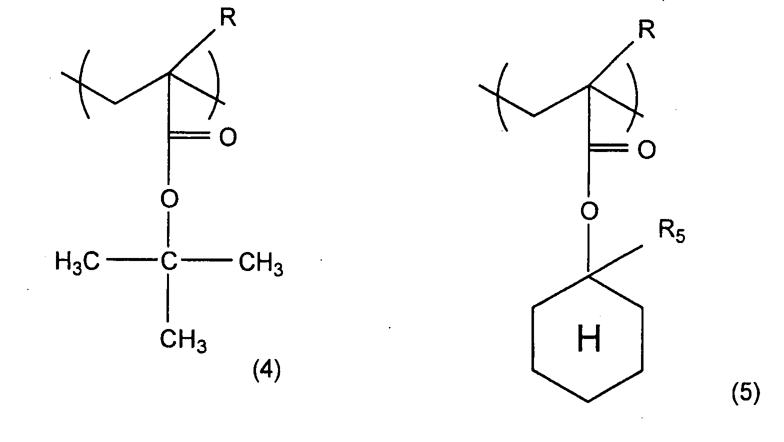

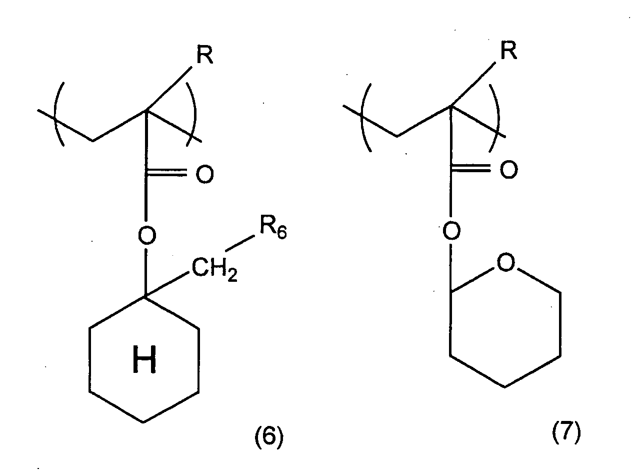

As the units (a1) shown above, the structural units shown by the general formulae (1), (2), and (3) are particularly preferred since they can be used to formpatterns with high transparency, high resolution, and high response to dry etching.

The unit (a2) bears a lactone unit and thus serves to increase affinity to a developing solution.

The unit (a2) may be any monomer unit that contains a lactone unit and can copolymerize with the other structural units of the resin component.

An example of monocyclic lactone unit is γ-butylolactone having one hydrogen atom removed. An example of polycyclic lactone unit is a lactone-containing polycycloalkane having one hydrogen atom removed.

Preferred monomer units for use as the unit (a2) are shown by the following general formulae (8) through (10). In these general formulae, R is hydrogen or methyl group.

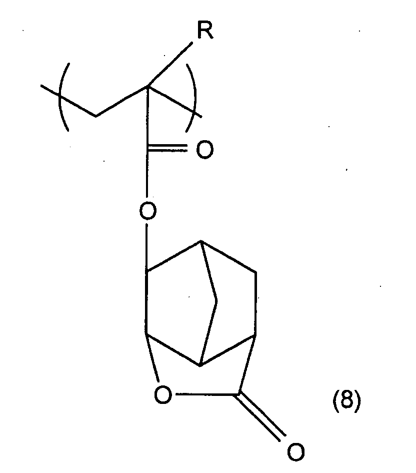

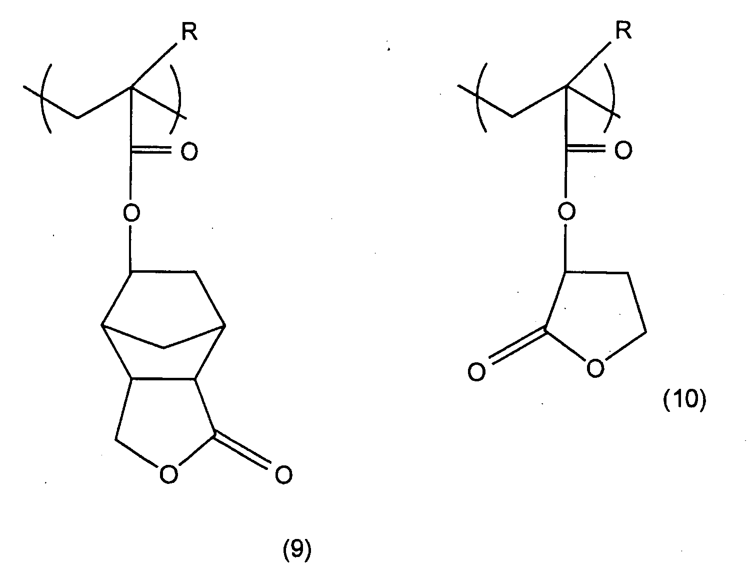

Of the units shown above, γ-butylolactone esters of (meth) acrylic acids that have an ester bond at the a-carbon and are represented by the general formula (10) and norbornane lactone esters as represented by the general formulae (8) and (9) are preferred because of their industrial availability.

The unit (a3) is a structural unit derived from a (meth) acrylate having a polycyclic group with an alcoholic hydroxyl group.

The hydroxyl group in the alcoholic hydroxyl group-containing polycyclic group is a polar group and acts to increase the affinity of the entire resin components to the developing solution. As a result, the exposed areas will more readily dissolve in an alkali solution. Thus, the resin component when containing (a3) gives an increased resolution and is thus preferred.

The polycyclic group in (a3) may be properly selected from the same aliphatic polycyclic groups as those described above with reference to (a1).

While the alcoholic hydroxyl group-containing polycyclic group is not limited to particular functional groups, hydroxyl-containing adamantyl group is preferred.

When having the structure shown by the following general formula (11), the hydroxyl-containing adamantyl group serves to increase resistance to dry etching and ensures vertical pattern cross section, and is thus preferred. In the general formula, 1 is an integer from 1 to 3.

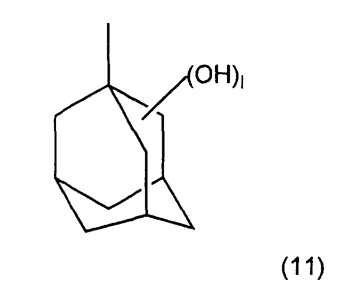

The unit (a3) may be any monomer unit that includes the above-described alcoholic hydroxyl group-containing polycyclic group and can copolymerize with the other structural units of the resin component.

Specifically, the structural units as represented by the following general formula (12) areparticularlypreferred. In the general formula (12), R is hydrogen or methyl group.

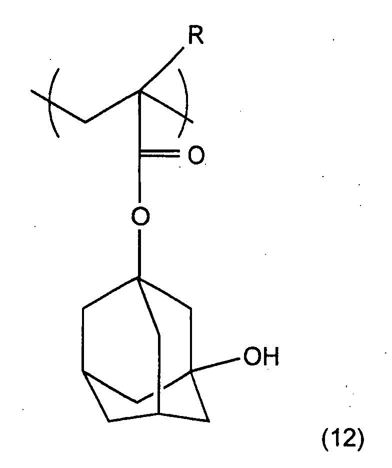

With regard to the unit (a4), the polycyclic group that "differs from any of the acid-dissociative anti-dissolving group, the lactone unit, and the alcoholic hydroxyl group-containing polycyclic group" means that the polycyclic group of the unit (a4) differs from any of the acid-dissociative anti-dissolving group of the unit (a1), the lactone unit of the unit (a2), and the alcoholic hydroxyl group-containing polycyclic group of the unit (a3). In other words, the unit (a4) bears none of the acid-dissociative anti-dissolving group of the unit (a1), the lactone unit of the unit (a2), and the alcoholic hydroxyl group-containing polycyclic group of the unit (a3) that together compose the resin component.

The polycyclic group of the unit (a4) may be any polycyclic group as long as it differs from any of the structural units used as (a1) through (a3) in one resin component. For example, the polycyclic group of the unit (a4) may be the same aliphatic polycyclic group as those described above with reference to the unit (a1). Many of conventional ArF positive type resist materials can be used.

The polycyclic group of the unit (a4) is preferably at least one selected from tricyclodecanyl group, adamantyl group, and tetracyclododecanyl group since they are industrially readily available.

The unit (a4) may be any structural unit that contains the above-described polycyclic group and can copolymerize with the other structural units of the resin component.

Preferred examples of the unit (a4) are given by the following general formulae (13) through (15). In the general formulae, R is hydrogen or methyl group.

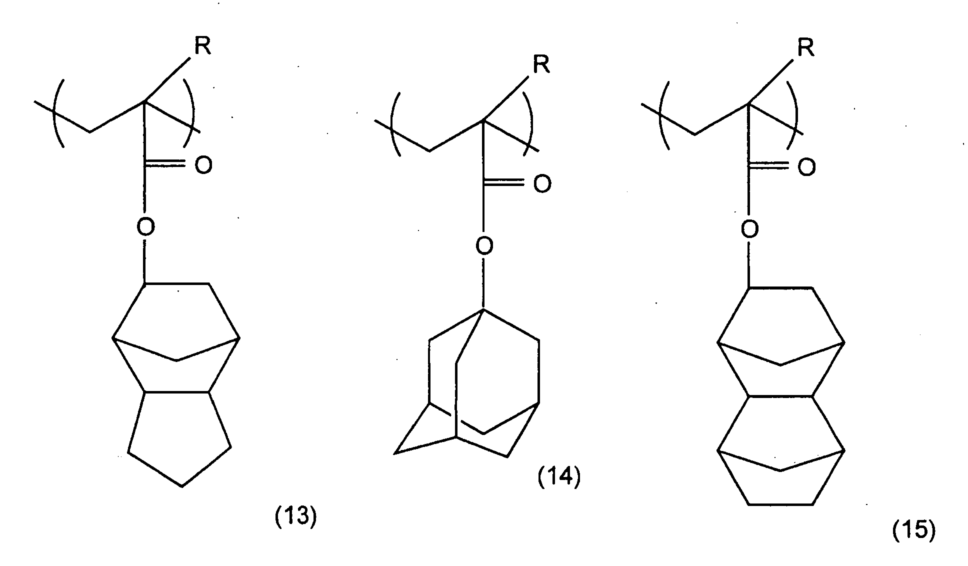

The composition of the acrylic resin component contains the unit (a1) in an amount of 20 to 60 mol % and preferably, in an amount of 30 to 50 mol % with respect to the total amount of the structural units composing the resin component. In this manner, high resolution is ensured.

The unit (a2) provides high resolution when present in an amount of 20 to 60 mol % and preferably, in an amount of 30 to 50 mol % with respect to the total amount of the structural units composing the resin component.

The unit (a3) ensures favorable resist patterning when present in an amount of 5 to 50 mol % and preferably, in an amount of 10 to 40 mol % with respect to the total amount of the structural units composing the resin component.

The unit (a4) ensures resolution of isolated patterns to semi-dense patterns when present in an amount of 1 to 30 mol % and preferably, in an amount of 5 to 20 mol % with respect to the total amount of the structural units composing the resin component.

While the unit (a1) may be used with at least one selected from the units (a2), (a3), and (a4) in a proper combination in accordance with the intended purpose, a terpolymer composed of the units (a1), (a2), and (a3) is preferred because of the resulting resist patterns, exposure tolerance, resistance to heat, and resolution. Preferred amounts of the structural units (a1), (a2), and (a3) are from 20 to 60 mol %, from 20 to 60 mol % and from 5 to 50 mol %, respectively.

While not limited to a particular molecular weight, the weight-average molecular weight (as determined using polystyrene standards. All weight-average molecular weights are determined using the same standards) of the resin component for use in the present invention is preferably in the range of 5000 to 30000 and more preferably, in the range of from 8000 to 20000. If the weight-average molecular weight exceeds this range, the resin component becomes less soluble in the resist solvent. If the weight-average molecular weight is less than this range, the resistance to dry etching will be decreased and the resulting resist pattern will be unfavorable.

The cycloolefin resin is preferably a resin composed of the structural unit (a5) shown by the following general formula (16), which may be optionally copolymerized with a structural unit obtained from the unit (a1) above: 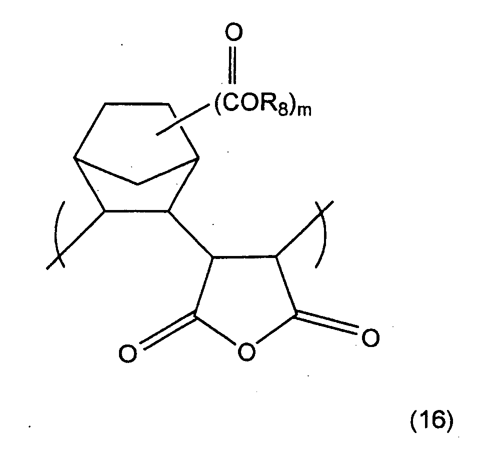 (wherein R₈ is a substituent as described above as the acid-dissociative anti-dissolving group with reference to the unit (a1); and m is an integer from 0 to 3).

When m is 0 in the unit (a5) above, the cycloolefin resin is preferably a copolymer copolymerized with the unit (a1).

The silsesquioxane resin may be a resin comprising the structural unit (a6) as shown by the following general formula (17) or a resin comprising the structural unit (a7) as shown by the following general formula (18): 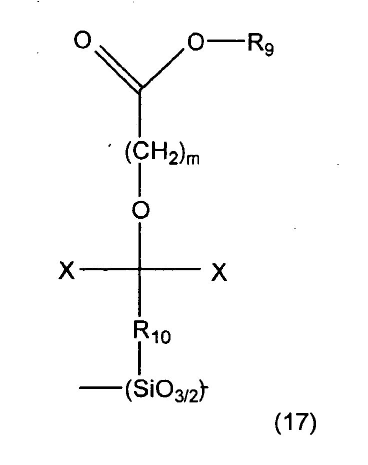 (wherein R₉ is an acid-dissociative anti-dissolving group comprising an aliphatic monocyclic or polycyclic hydrocarbon; R₁₀ is a straight-chained, branched, or cyclic saturated aliphatic hydrocarbon:
X is an alkyl group having 1 to 8 carbon atoms and having at least one hydrogen atom substituted with fluorine; and m is an integer from 1 to 3); 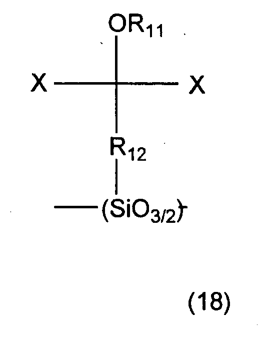 (wherein R₁₁ is hydrogen or straight-chained, branched, or cyclic alkyl group; R₁₂ is a straight-chained, branched, or cyclic saturated aliphatic hydrocarbon; X is an alkyl group having 1 to 8 carbon atoms and having at least one hydrogen atom substituted with fluorine.)

In the (a6) and (a7) above, the acid-dissociative anti-dissolving group of R₉ is a functional group that keeps the entire silsesquioxane resin insoluble in an alkali solution prior to exposure and, following exposure, dissociates as it is acted upon by an acid generated from an acid-generating agent, making the entire silsesquioxane resin soluble in an alkali solution.

Preferred examples of such acid-dissociative anti-dissolving groups include those shown by the following general formulae (19) through (23), which comprise a hydrocarbon having a bulky, monocyclic or polycyclic aliphatic group. These acid-dissociative anti-dissolving groups serve to keep the anti-dissolving groups from forming a gas after dissociation and suppress degassing.

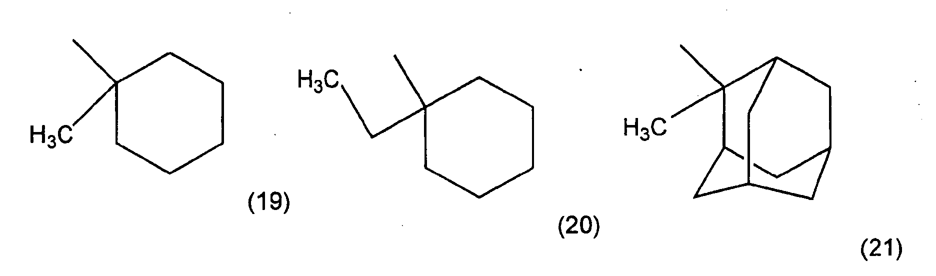

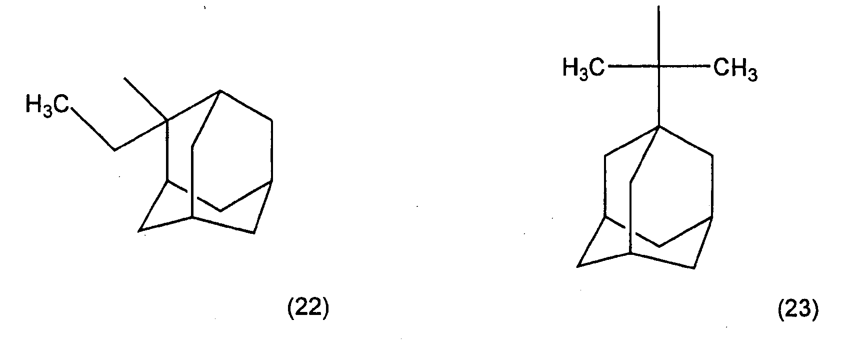

R₉ preferably has 7 to 15 carbon atoms, more preferably 9 to 13 carbon atoms to keep the anti-dissolving groups from forming a gas upon dissociation and ensure proper solubility in a resist solvent and a developing solution.

The acid-dissociative anti-dissolving groups comprise hydrocarbons having an aliphatic monocyclic or polycyclic group and may be selected from many of those proposed as resins for use in resist compositions depending on the type of the light source used, for example ArF excimer laser. Those that can form a cyclic tertiary alkyl ester with a carboxyl group of (meth)acrylates are commonly known.

The acid-dissociative anti-dissolving groups preferably contain an aliphatic polycyclic group. Such aliphatic polycyclic groups may be properly selected frommany of those proposed for use with ArF resists. Examples of such an aliphatic polycyclic group include bicycloalkane, tricycloalkane and teroracycloalkane from which single hydrogen atom has been removed. Specific examples include polycycloalkanes, such as adamantane, norbornane, isobornane, tricyclodecane and tetracyclododecane, from which single hydrogen atom has been removed.

Silsesquioxane resins that have a 2-methyladamantyl group as shown by the general formula (21) and/or a 2-ethyladamantyl group as shown by the general formula (22) are preferred since they hardly cause degassing while offering favorable resist properties such as resolution and resistance to heat.

R₁₀ and R₁₂ preferably have 1 to 20 carbon atoms, more preferably 5 to 12 carbon atoms in view of the solubility in a resist solvent and control over the size of the molecules. Cyclic saturated aliphatic hydrocarbons are particularly preferred since the resulting silsesquioxane resins have high transparency to high energy light and have high glass transition point (Tg), facilitating control of the generation of an acid from the acid-generating agent upon PEB (post exposure bake).

The cyclic saturated aliphatic hydrocarbon group may be either monocyclic or polycyclic. Examples of the polycyclic group include bicycloalkane, tricycloalkane and teroracycloalkane from which two hydrogen atoms have been removed. Specific examples include polycycloalkanes, such as adamantane, norbornane, isobornane, tricyclodecane and tetracyclododecane from which two hydrogen atoms have been removed.

More specifically, R₁₀ and R₁₂ may be an alicyclic compound or a derivative thereof as shown by the following general formulae (24) through (29) having two hydrogen atoms removed:

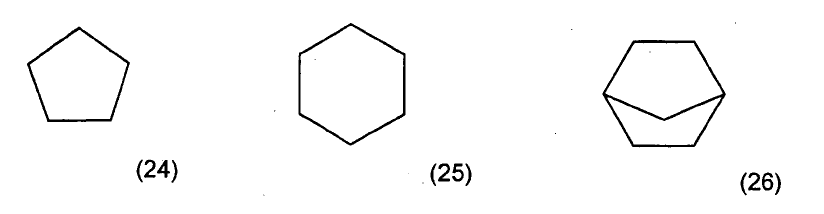

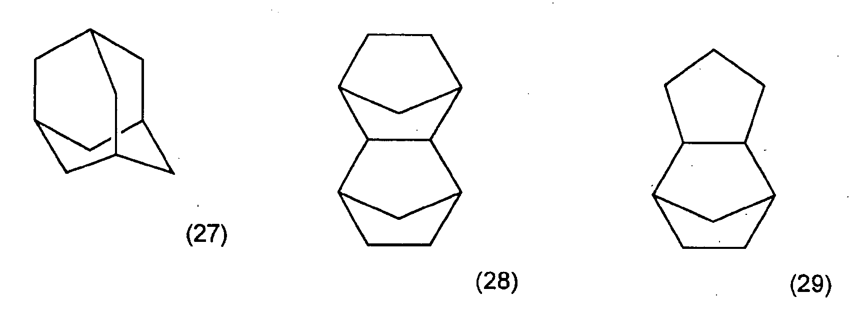

The term "derivative" above refers to the alicyclic compounds shown by the chemical formulae (24) through (29) above means that at least one hydrogen atom has been substituted with a lower alkyl group, such as methyl group and ethyl group, oxygen atom, and halogen atom, such as fluorine, chlorine and bromine. Among them, alicyclic compounds selected from those represented by the chemical formulae (24) through (29) having two hydrogen atoms removed are preferred because of their high transparency and industrial availability.

R₁₁ is preferably a lower alkyl group having 1 to 10 carbon atoms, more preferably 1 to 4 carbon atoms to ensure solubility in a resist solvent. Examples of such an alkyl group include methyl group, ethyl group, propyl group, isopropyl group, n-butyl group, sec-butyl group, tert-butyl group, cyclopentyl group, cyclohexyl group, 2-ethylhexyl group and n-octyl group.

R₁₁ is properly selected from the above candidates depending on the desired solubility of the silsesquioxane resin in an alkali solution. The highest solubility in an alkali solution is achieved when R₁₁ is hydrogen. A higher solubility in an alkali solution offers an advantage that the resulting resin has higher sensitivity.

As the above-described alkyl group has more carbon atoms or becomes bulkier, the solubility of the resultant silsesquioxane resin in an alkali solution is decreased. The decreased solubility in an alkali solution leads to an increase in the resistance of the resin to alkali developing solution, so that the exposure margin is improved during resist patterning using the silsesquioxane resin. As a result, the size variation upon exposure is minimized. In addition, the decreased solubility in an alkali solution eliminates nonuniform development and, thus, improves roughness at the edges of the resulting resist patterns.

Preferably, X in the general formulae (17) and (18) is a straight-chained alkyl group. The alkyl group is a lower alkyl group that has 1 to 8 carbon atoms, preferably 1 to 4 carbon atoms in view of the glass transition point (Tg) and the solubility in a resist solvent of the silsesquioxane resin. The alkyl group preferably has more hydrogen atoms substituted with fluorine atoms since transparency to high energy light of 200 nm or shorter wavelengths or electron beam can be increased in this manner. Most preferably, the alkyl group is a perfluoroalkyl group that has all of its hydrogen atoms substituted with fluorine atoms. Xs may or may not be identical to one another. "m" in the general formula (17) is an integer from 1 to 3, preferably 1, so that the acid-dissociative anti-dissolving group can readily dissociate.

More specifically, the silsesquioxane resin may be one shown by the following general formula (30) or (31): 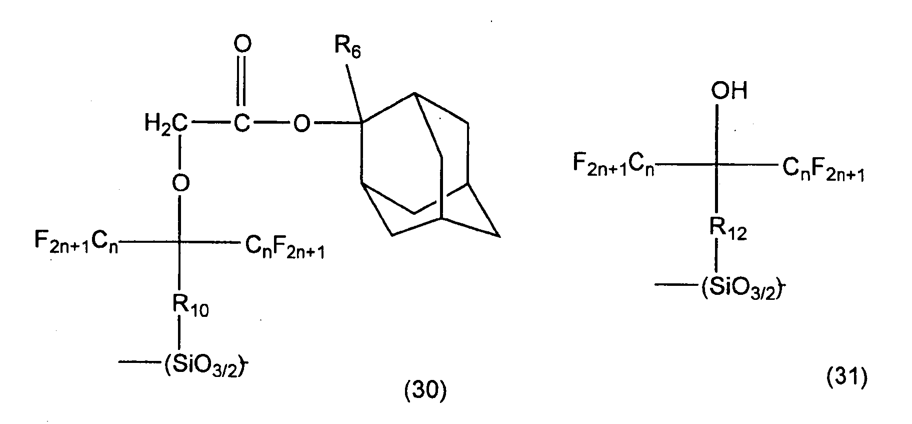 (wherein R₆, R₁₀, R₁₂, and n are same as those defined above).

The structural units (a6) and (a7) typically compose 30 to 100 mol %, preferably 70 to 100 mol %, more preferably 100 mol % of the entire structural units forming the silsesquioxane resin of the present invention.

The proportion of the structural unit (a6) with respect to the total amount of the structural units (a6) and (a7) is preferably 5 to 70 mol %, and more preferably 10 to 40 mol %. The proportion of the structural unit (a7) is preferably 30 to 95 mol %, and more preferably 60 to 90 mol %.

Adjusting the proportion of the structural unit (a6) within the above range automatically determines the proportion of the acid-dissociative anti-dissolving group, so that the change in the solubility of the silsesquioxane resin in an alkali solution before and after exposure becomes suitable for a base resin of a positive type resist composition.

As long as the advantages of the present invention are not affected, the silsesquioxane resin may contain additional structural units other than (a6) and (a7). Such additional structural units may be those that have been used in silsesquioxane resins for use in resist compositions for ArF excimer laser. Examples include alkyl silsesquioxane units having alkyl groups, such as methyl group, ethyl group, propyl group and butyl group.

The silsesquioxane resin preferably has a weight-average molecular weight (Mw) (as determined by using polystyrene standards in gel permeation chromatography) of 2000 to 15000, more preferably 3000 to 8000, while it may have any weight-average molecular weight. The silsesquioxane resin with a weight-average molecular weight greater than this range is hardly soluble in a resist solvent, whereas the resin with too small a molecular weight may affect the resist pattern cross section.

The value of the weight-average molecular weight (Mw)/the number-average molecular weight (Mn) is preferably in the range of 1.0 to 6.0, and more preferably in the range of 1.5 to 2.5 while it may take any value. If this value is greater than the specified range, then the resolution and the pattern shape may be deteriorated.

Having the silsesquioxane backbone composed of the structural units (a6) and (a7), the silsesquioxane resin of the present invention has high transparency to high energy light of 200 nmor shorter wavelengths and electron beam. For this reason, the positive type resist composition containing the silsesquioxane resin of the present invention is suitable for use in lithography that uses light sources that emit light with shorter wavelengths than ArF excimer laser. The positive type resist composition can be used to form fine resist patterns with a line width of 150 nm or less, in particular 120 nm or less, in the single layer process. When used in the upper layer of a two-layered laminate, the positive type resist composition allows formation of fine resist patterns with a line width of 120 nm or less, in particular 100 nm or less.

While the resin component for use in the above-described negative type resist composition may be any conventional resin component used for this purpose, it is preferably a resin component as described below.

Specifically, the resin component (a8) is such that it becomes insoluble when acted upon by an acid and includes two functional groups that react with each other to form an ester. When an acid is generated from an acid-generating agent, which is added to the resist material along with the resin component, the acid acts on the resin component and, as a result, the resin component is dehydrated to form an ester, thereby becoming insoluble in an alkali solution. What is meant by saying "two functional groups that react with each other to form an ester" is, for example, a combination of a hydroxyl group and a carboxyl group or a carboxylate that together form a carboxylic acid ester. In other words, these are two functional groups that together form an ester. Preferably, such a resin has a hydroxyalkyl group and at least one of carboxylic group and carboxylate on side chains of the resin backbone.

The resin component may be a resin component (a9) composed of a polymer comprising a dicarboxylic acid monoester unit.

In other words, the unit (a8) is a resin component comprising at least the structural unit shown by the following general formula (32) : 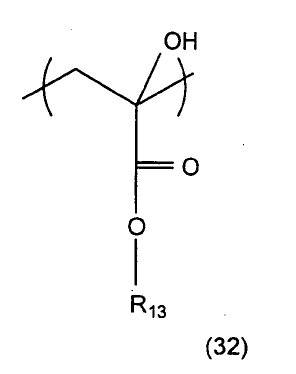 (wherein R₁₃ is hydrogen, alkyl group having 1 to 6 carbon atoms, or alkyl group having a polycyclic ring structure, such as bornyl group, adamantyl group, tetracyclododecyl group and tricyclodecyl group).

Examples of such a resin include a polymer (a8-1) (homopolymer or copolymer) composed of at least one monomer selected from a- (hydroxyalkyl) acrylic acids and a- (hydroxyalkyl) acrylic acid alkyl esters; and a copolymer (a8-2) composed of at least one monomer selected from a- (hydroxyalkyl) acrylic acids and a- (hydroxyalkyl) acrylic acid alkyl esters and at least one monomer selected from other ethylenic unsaturated carboxylic acids and ethylenic unsaturated carboxylates.

Preferably, the polymer (a8-1) is a copolymer of a- (hydroxyalkyl) acrylic acid and a- (hydroxyalkyl) acrylic acid alkyl ester. Preferably, the copolymer (a8-2) uses, as the other ethylenic unsaturated carboxylic acids or ethylenic unsaturated carboxylates, at least one selected from acrylic acids, methacrylic acids, alkyl esters of acrylic acids and alkyl esters of methacrylic acids.

Examples of the hydroxyalkyl group in the a- (hydroxyalkyl) acrylic acids and a- (hydroxyalkyl)acrylic acid alkyl esters are lower hydroxyalkyl groups, including hydroxymethyl group, hydroxyethyl group, hydroxypropyl group and hydroxybutyl group. Among them, hydroxyethyl group and hydroxymethyl group are preferred since they readily form esters.

Examples of the alkyl group in the alkylester moieties of the a- (hydroxyalkyl) acrylic acid alkyl esters include lower alkyl groups, such as methyl group, ethyl group, propyl group, isopropyl group, n-butyl group, sec-butyl group, tert-butyl group and amyl group; and crosslinked polycyclic ring hydrocarbons, such as bicyclo[2.2.1]heptyl group, bornyl group, adamantyl group, tetracyclo [4.4.0.1^{2.5}.1^{7.10}] dodecyl group and tricyclo [5.2.1.0^{2.6}] decyl group. The alkyl esters in which the alkyl group of the ester moiety is a polycyclic ring hydrocarbon are effective in increasing resistance to dry etching. The alkyl esters having a lower alkyl group, such as methyl group, ethyl group, propyl group or butyl group are preferred since the alcohols used to form the esters are inexpensive and readily available.

In the case of the lower alkyl esters, in which esterification takes place with both carboxyl groups and hydroxyalkyl groups, esterification can hardly take place for the esters formed with the crosslinked polycyclic ring hydrocarbons. Thus, when it is desired to introduce an ester with a crosslinked polycyclic ring hydrocarbons into the resin, the resin preferably contains carboxyl groups on its side chains.

Examples of the other ethylenic unsaturated carboxylic acids and ethylenic unsaturated carboxylates used in the (a8-2) include unsaturated carboxylic acids of acrylic acid, methacrylic acid, maleic acid, and fumaric acid, and alkyl esters of these unsaturated carboxylic acids, such as methyl, ethyl, propyl, isopropyl, n-butyl, isobutyl, n-hexyl, and octyl esters. Examples of the alkyl group in the ester moieties include esters of acrylic acids or methacrylic acids having crosslinked polycyclic ring hydrocarbons, such as bicyclo [2.2.1] heptyl group, bornyl group, adamantyl group, tetracyclo[4.4.0.1^{2.5}.1^{7.10}]dodecyl group, and tricyclo[5.2.1.0^{2.6}]decyl group. Among them, acrylic acids and methacrylic acids, and lower alkyl esters thereof , such as methyl, ethyl, propyl, andn-butyl esters are preferred because of their cost efficiency and availability.

In the resin formed of the resin component (a8-2), the at least one monomer unit selected from a- (hydroxyalkyl)acrylic acids and a- (hydroxyalkyl) acrylic acid alkyl esters and the at least one monomer unit selected from the other ethylenic unsaturated carboxylic acids and ethylenic unsaturated carboxylates are present at a molar ratio of 20 : 80 to 95 : 5, in particular, at a molar ratio of 50 : 50 to 90 : 10. With the both units falling within the respective ranges, intramolecular or intermolecular esters are readily formed and, as a result, improved resist patterns can be obtained.

The resin component (a9) comprises at least the structural units shown by the following general formula (33) or (34): 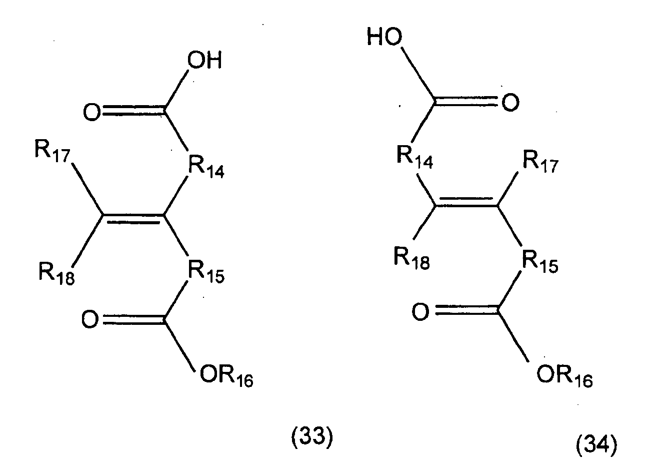 (wherein R₁₄ and R₁₅ are each alkyl chain having 0 to 8 carbon atoms; R₁₆ is a substituent having at least two alicyclic structures; and R₁₇ and R₁₈ are each hydrogen or alkyl group having 1 to 8 .carbon atoms).

The negative type resist compositions using the resin component comprising such a dicarboxylic acid monoester monomer unit provide high resolution and reduce the line edge roughness and is thus preferred. Such resist compositions have high resistance to swelling and are particularly suitable for use in liquid immersion lithography.

Examples of such dicarboxylic acid monoester compounds include fumaric acid, itaconic acid, mesaconic acid, glutaconic acid and traumatic acid.

Preferred resins comprising the dicarboxylic acid monoester unit include polymers or copolymers (a9-1) of a dicarboxylic acid monoester monomer; and copolymers (a9-2) of a dicarboxylic acid monoester monomer and at least one monomer selected from the above-described a-(hydroxyalkyl)acrylic acids, a-(hydroxyalkyl)acrylic acid alkyl esters, the other ethylenic unsaturated carboxylic acids, and ethylenic unsaturated carboxylates.

The resin components of the negative type resist may be used either individually or in combination of two or more. The resin component has a weight-average molecular weight of 1000 to 50000, preferably 2000 to 30000.

Many fluorine-containing polymers have been proposed for use as resin components of F₂ positive type resists. Any of these polymers may be used in the present invention. Of such polymers, preferred are fluorine-containing polymers (a10) comprising an alkali-soluble structural unit (a10-1) containing an aliphatic cyclic group that has both of (i) fluorine atom or fluorinated alkyl group and (ii) alcoholic hydroxyl group. Preferably, the solubility of these polymers in an alkali solution changes when the polymers are acted upon by an acid.

What is meant by saying "the solubility of the polymer (a10) changes when the polymer is acted upon by an acid" is the change of the polymer that takes place in the exposed area. Specifically, if the solubility of the polymer in an alkali solution increases in the exposed area, then the exposed area becomes soluble in an alkali solution, so that the polymer can serve as a positive type resist. Conversely, if the solubility in an alkali solution decreases in the exposed area, then the exposed area becomes insoluble in an alkali solution, so that the polymer can serve as a negative type resist.

The alkali-soluble structural unit (a10-1) containing an aliphatic cyclic group that has both of (i) fluorine atom or fluorinated alkyl group and (ii) alcoholic hydroxyl group may be any structural unit in which an organic functional group bearing both (i) and (ii) is bonded to an aliphatic cyclic group and such a cyclic group is present in the structural unit of the polymer.

The aliphatic cyclic group may be a monocyclic or polycyclic hydrocarbon, such as cyclopentane, cyclohexane, bicycloalkane, tricycloalkane, and teroracycloalkane, that has one or more hydrogen atoms removed.

Specific examples of the polycyclic hydrocarbon include polycycloalkanes, such as adamantane, norbornane, isobornane, tricyclodecane and tetracyclododecane, from which one or more hydrogen atoms have been removed.

Of these functional groups, those derived by removing hydrogen atoms from cyclopentane, cyclohexane or norbornane are industrially preferred.

The fluorine atom or fluorinated alkyl group (i) may be a fluorine atom or lower alkyl group that has some or all of its hydrogen atoms substituted with fluorine atoms. Specific examples include trifluoromethyl group, pentafluoroethyl group, heptafluoropropyl group and nonafluorobutyl group. Fluorine atom and trifluoromethyl group are industrially preferred.

The alcoholic hydroxyl group (ii) may be simply a hydroxyl group, or it may be an alcoholic hydroxyl group-containing alkyloxy group, alcoholic hydroxyl group-containing alkyloxyalkyl group, or alcoholic hydroxyl group-containing alkyl group, such as hydroxyl-containing alkyloxy group, alkyloxyalkyl group or alkyl group. The alkyloxy group, alkyloxyalkyl group and alkyl group are preferably lower alkyloxy group, lower alkyloxy lower alkyl group and lower alkyl group, respectively.

Examples of the lower alkyloxy group are methyloxy group, ethyloxy group, propyloxy group and buthyloxy group. Examples of the lower alkyloxy lower alkyl group are methyloxymethyl group, ethyloxymethyl group, propyloxymethyl group and butyloxymethyl group. Examples of the lower alkyl group are methyl group, ethyl group, propyl group and butyl group.

The alcoholic hydroxyl group-containing alkyloxy group, alcoholic hydroxyl group-containing alkyloxyalkyl group or alcoholic hydroxyl group-containing alkyl group (ii) may have some or all of the hydrogen atoms of its alkyloxy group, alkyloxyalkyl group or alkyl group substituted with fluorine atoms.

Preferably, the alkyloxy moiety of the alcoholic hydroxyl group-containing alkyloxy group or the alcoholic hydroxyl group-containing alkyloxyalkyl group has some of its hydrogen atoms substituted with fluorine atoms. Preferably, the alkyl moiety of the alcoholic hydroxyl group-containing alkyl group has its hydrogen atoms substituted with fluorine atoms. Specific examples are alcoholic hydroxyl group-containing fluoroalkyloxy groups, alcoholic hydroxyl group-containing fluoroalkyloxyalkyl groups, and alcoholic hydroxyl group-containing fluoroalkyl groups.

Examples of the alcoholic hydroxyl group-containing fluoroalkyloxy group include (HO)C(CF₃)₂CH₂O- group (2-bis(hexafluoromethyl)-2-hydroxy-ethyloxy group and (HO)C(CF₃)₂CH₂CH₂O- group
3-bis(hexafluoromethyl)-3-hydroxy-propyloxy group. Examples of the alcoholic hydroxyl group-containing fluoroalkyloxyalkyl group include (HO)C(CF₃)₂CH₂O-CH₂- group and (HO)C(CF₃)₂CH₂CH₂O-CH₂- group. Examples of the alcoholic hydroxyl group-containing fluoroalkyl group include (HO)C(CF₃)₂CH₂- group (2-bis(hexafluoromethyl)-2-hydroxy-ethyl group and (HO)C(CF₃)₂CH₂CH₂- group 3-bis (hexafluoromethyl)-3-hydroxy-propyl group.

The groups (i) and (ii) may be directly bonded to the aliphatic cyclic group. Preferably, the structural unit (a10-1) is a unit shown by the following general formula (35), which is formedwhen the norbornene ring is bonded to the alcoholic hydroxyl group-containing fluoroalkyloxy group, the alcoholic hydroxyl group-containing fluoroalkyloxyalkyl group or the alcoholic hydroxyl group-containing fluoroalkyl group, and the double bond in the norbornene ring opens. This structural unit provides high transparency, high alkali solubility, and high resistance to dry etching and is industrially readily available. 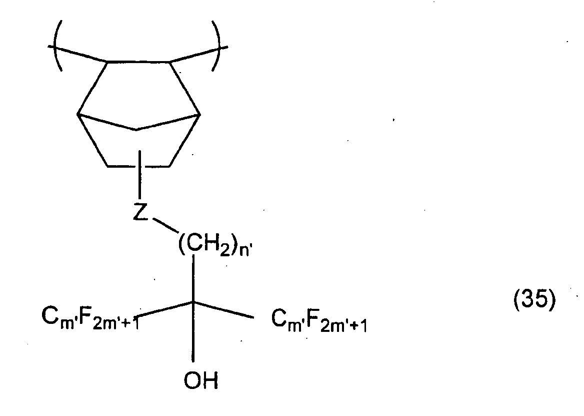 (wherein Z is oxygen atom, oxymethylene group (-O(CH₂)-) or single bond; and n' and m' are each independently an integer from 1 to 5).

The polymer unit used in conjunction with the unit (a10-1) may be any known polymer unit. When the polymer is used as a positive type polymer that becomes soluble in an alkali solution when acted upon by an acid, the structural unit (a1), derived from (meth) acryl ester having the above-described acid-dissociative anti-dissolving group, is preferably used since it ensures high resolution.

Preferably, the structural unit (a1) is derived from a tertiary alkyl ester of (meth) acrylic acids, such as tert-butyl (meth) acrylates and tert-amyl (meth)acrylates.

The polymer (a10) may be a polymer (a11) that comprises the fluorinated alkylene structural unit (a10-2) to improve transparency of the polymer and becomes soluble in an alkali solution when acted upon by an acid. The presence of the structural unit (a10-2) further improves the transparency of the polymer. The structural unit (a10-2) is preferably derived from tetrafluoroethylene.

The polymer (a10) and the polymer (a11) are represented by the following general formulae (36) and (37), respectively: 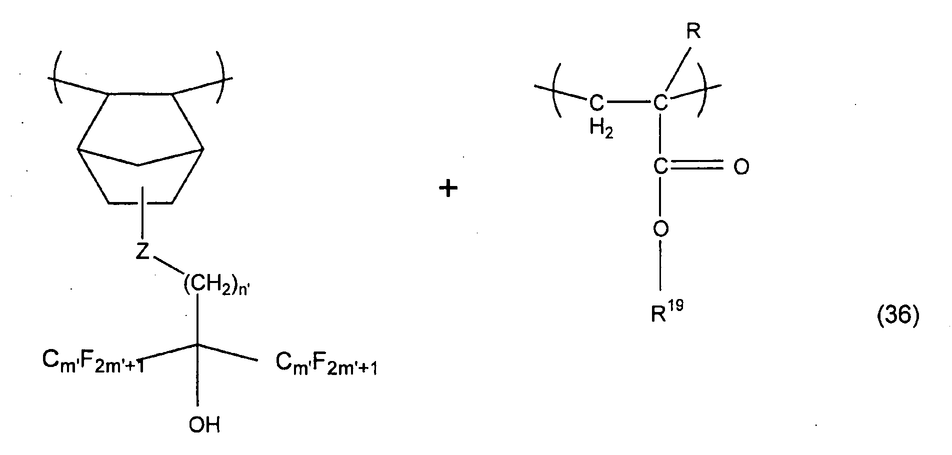 (wherein Z, n' and m' are the same as in the general formula (35); R is hydrogen or methyl group; and R¹⁹ is an acid-dissociative anti-dissolving group); 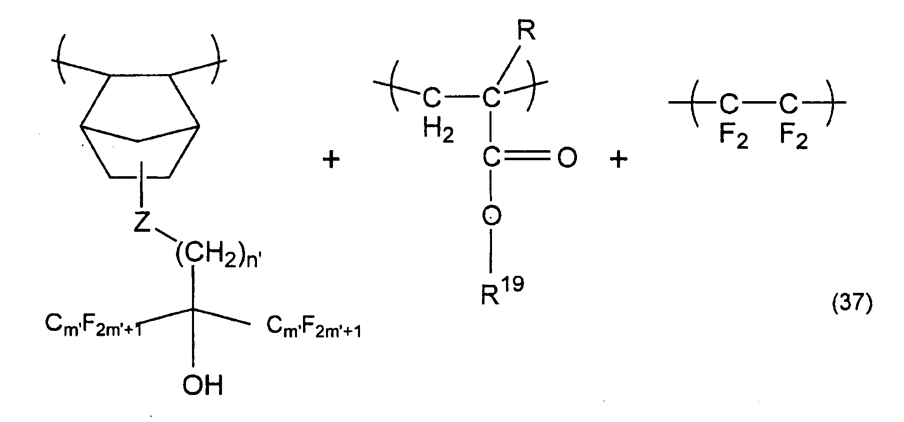 (wherein Z, n', m', R and R¹⁹ are the same as in the general formula (36)).

As a polymer, which comprises another structural unit (a10-1) that differs from the polymer (a10) and the polymer (a11) and whose solubility in an alkali solution changes when acted upon by an acid, may be a polymer having the following structure unit.

Specifically, in the structural unit (a10-1), (i) fluorine atom or fluorinated alkyl group and (ii) alcoholic hydroxyl group are each bonded to an aliphatic cyclic group, which forms the backbone.

The fluorine atom or fluorinated alkyl group (i) may be the same as that described above. The alcoholic hydroxyl group (ii) is simply a hydroxyl group.

A polymer (a12) comprising such a unit is formed through cyclic polymerization of a hydroxyl group and a diene compound having a fluorine atom. The diene compound is preferably a heptadiene, which can readily form a five-membered or six-membered ring and provides high transparency and high resistance to dry etching. Polymers formed through cyclic polymerization of 1, 1, 2, 3,3-pentafluoro-4-trifluoromethyl-4-hydroxy-1, 6-heptadiene (CF₂=CFCF₂C(CF₃) (OH)CH₂CH=CH₂) are industrially most preferred.

A polymer (a13) of positive type that becomes soluble in an alkali solution when acted upon by an acid may also be used. The polymer (a13) preferably comprises a structural unit (a10-3) in which hydrogen atoms of the alcoholic hydroxyl group have been substituted with acid-dissociative anti-dissolving groups. In view of acid dissociation, the acid-dissociative anti-dissolving group is preferably a straight-chained, branched or cyclic alkyloxymethyl group having 1 to 15 carbon atoms. Lower alkoxymethyl groups, such as methoxymethyl group are particularly preferred since they provide high resolution and ensure good patterning shape. The acid-dissociative anti-dissolving groups can ensure good formative ability of patterns when accounting for 10 to 40%, preferably 15 to 30% of the entire hydroxyl groups.

The polymer (a13) are represented by the following general formula (38) : 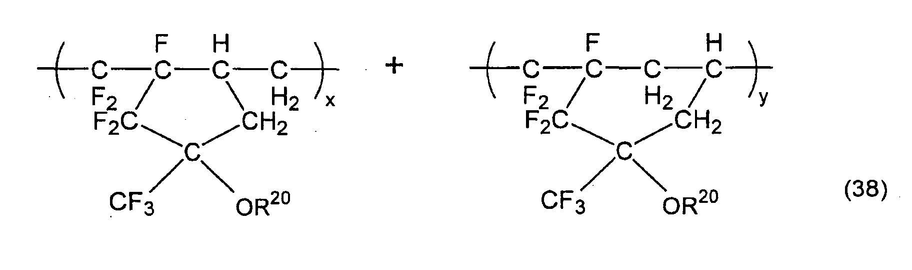 (wherein R²⁰ is hydrogen or alkyloxymethyl group having 1 to 15 carbon atoms; and x and y are each 10 to 50 mol %).

The polymers (a10), (a11), (a12), and (a13) can be synthesized by using techniques described in non-patent articles such as S. Kodama et al., "Synthesis of Novel Fluoropolymer for 157 nm Photoresists by Cyclo-polymerization" Proceedings of SPIE, Vol. 4690, (2002) pp76-83, and patent articles such as International Patent Publication No. WO 00/67072 pamphlet, International Patent Publication No. WO 02/65212 pamphlet, and International Patent Publication No. WO 02/64648 pamphlet.

The resin composed of the components (a10), (a11), (a12), and (a13) has a weight-average molecular weight (as determined by GPC using polystyrene standards) preferably in the range of 5000 to 80000, and more preferably in the range of 8000 to 50000 while the resin may have any weight-average molecular weight.

The polymer (a10) may be composed of one or two or more of resins, and for example, two or more selected from the (a10), (a11), (a12), and (a13) may be mixed and conventionally known resins for photoresist composition may further be added.

Of the resins described above, the positive type resists using the acrylic resins (a1) through (a4) contain resins that are relatively resistant to liquid immersion. When used as the immersion medium, the immersion fluid of the present invention can elicit comparable or higher effects. The effect of the immersion fluid of the present invention will become prominent near the resolution limit of approximately 50 nm or less.

The positive type resists using the silsesquioxane resins ((a6) and (a7)) have a lower resistance to liquid immersion than those using the acrylic resins. Nonetheless, the aptitude of the photoresists for liquid immersion lithography can be improved by the use of the immersion fluid of the present invention.

Similar to the positive type resists using the silsesquioxane resins, the negative type photoresists using the resins (a8) and/or (a9) have a lower resistance to liquid immersion than those of the positive type resists using the acrylic resins. Nonetheless, swelling and other effects of liquid immersion can be reduced by the use of the immersion fluid of the present invention. In the negative type resists, the line edge roughness can also be improved.

The present inventors realize that the cycloolefine resins can achieve very low resistance to liquid immersion lithography, making the patterning impossible, as described in the Comparative Example. The immersion fluid of the present invention even allows the use of these resins in liquid immersion lithography.

Thus, the immersion fluid of the present invention serves as a useful tool for extending the use of the liquid immersion lithography to the resists using resins with low resistance to liquid immersion.

The resists using the fluorine-containing polymers are mainly used in F₂ excimer laser lithography. The immersion fluid of the present invention is also suitable for use in liquid immersion lithography using excimer laser with a wavelength of 157 nm.

The acid-generating agent for use with the above-described resin components of positive or negative type resists may be any known acid-generating agent conventionally used in chemical amplification type resists.

Examples of such an acid-generating agent include onium salts, such as diphenyliodonium trifluoromethanesulfonate, (4-methoxyphenyl)phenyliodonium trifluoromethanesulfonate, bis(p-tert-butylphenyl)iodonium trifluoromethanesulfonate, triphenylsulfonium trifluoromethanesulfonate, (4-methoxyphenyl)diphenylsulfonium trifluoromethanesulfonate, (4-methylphenyl)diphenylsulfonium nonafluorobutanesulfonate, (p-tert-butylphenyl)diphenylsulfonium trifluoromethanesulfonate, diphenyliodonium nonafluorobutanesulfonate, bis(p-tert-butylphenyl)iodonium nonafluorobutanesulfonate, triphenylsulfonium nonafluorobutanesulfonate, (4-trifluoromethylphenyl)diphenylsulfonium trifluoromethanesulfonate, (4-trifluoromethylphenyl)diphenylsulfonium nonafluorobutanesulfonate, and tri(p-tert-butylphenyl)sulfonium trifluoromethanesulfonate.

Of these onium salts, triphenylsulfonates are less susceptible to decomposition and generate little organic gases and are, thus, favored. The triphenylsulfonate is added preferably in an amount of 50 to 100 mol %, more preferably in an amount of 70 to 100 mol %, and most preferably in an amount of 100 mol % with respect to the total amount of the acid-generating agent.

Among triphenylsulfonates, those shown by the following general formula (39) and having perfluoroalkylsulfonic acid ion as its anion can be used to increase the sensitivity and are, thus, preferred: 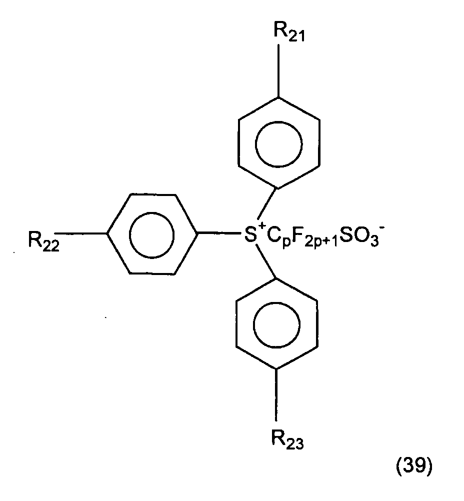 (wherein R₂₁, R₂₂, and R₂₃ are each independently hydrogen, lower alkyl group having 1 to 8, preferably 1 to 4 carbon atoms, or halogen, such as chlorine, fluorine and bromine; and p is an integer from 1 to 12, preferably from 1 to 8 and more preferably from 1 to 4).

The above-described acid-generating agents may be used either individually or in combination of two or more. The acid-generating agent is added in an amount of 0.5 parts by weight, and preferably in an amount of 1 to 10 parts by weight with respect to 100 parts by weight of the above-described resin component. If the amount of the acid-generating agent is less than 0.5 parts by weight, then sufficient pattern formation cannot be achieved. If the amount of the acid-generating agent is more than 30 parts by weight, then it becomes difficult to obtain a uniform solution, resulting in a decreased stability during storage.

The positive or negative type resist compositions of the present invention are produced by dissolving the resin component, the acid-generating agent, and the below-described optional components preferably in an organic solvent.

The organic solvent may be any organic solvent that can dissolve the resin component and the acid-generating agent to form a uniform solution. One or two or more solvents may be selected from known solvents for use with chemical amplification type resists.

Examples of the organic solvent include ketones, such as acetone, methyl ethyl ketone, cyclohexanone, methylisoamylketone and 2-heptanone; polyhydric alcohols and derivatives thereof, such as monomethyl ether, monoethyl ether, monopropyl ether, monobutyl ether and monophenyl ether of ethylene glycol, ethylene glycol monoacetate, diethylene glycol, diethylene glycol monoacetate, propylene glycol, propylene glycol monoacetate, dipropylene glycol and dipropylene glycol monoacetate; cyclic ethers such as dioxane; and esters, such as methyl lactate, ethyl lactate, methyl acetate, ethyl acetate, butyl acetate, methyl pyruvate, ethyl pyruvate, methyl methoxypropionate and ethyl ethoxypropionate. These organic solvents may be used either individually or in combination of two or more.

As a quencher, a known amine, preferably a secondary lower aliphatic amine or a tertiary lower aliphatic amine, or an organic acid, such as an organic carboxylic acid, and oxo acid of phosphorus, may be added to the positive or negative type resists for the purpose of improving the shape and the stability over time of resist patterns.

The lower aliphatic amine refers to amines of alkyl or alkyl alcohol having 5 or less carbon atoms. Examples of the secondary or tertiary amine include trimethylamine, diethylamine, triethylamine, di-n-propylamine, tri-n-propylamine, tribentylamine, diethanolamine and triethanolamine. Alkanolamines, such as triethanolamine, are particularly preferred. These amines may be used either individually or in combination of two or more.

The amine is typically used in an amount of 0.01 to 2.0 weight % with respect to the resin component.

The organic carboxylic acid is preferably malonic acid, citric acid, malic acid, succinic acid, benzoic acid and salicylic acid.

Examples of the oxo acid of phosphorus or derivatives thereof include phosphoric acid and derivatives, such as esters, thereof, including phosphoric acid, di-n-butyl phosphate, and diphenyl phosphate; phosphonic acid and derivatives, such as esters, thereof, including phosphonic acid, dimethyl phosphonate, di-n-butyl phosphonate, phenyl phosphonate, diphenyl phosphonate, and dibenzyl phosphonate; and phosphinic acid and derivatives, such as esters, thereof, includingphosphinic acid and phenyl phosphinate. Among them, phosphonic acid is particularly preferred.

The organic acid is used in an amount of 0.01 to 5.0 parts by weight with respect to 100 parts by weight of the resin component. The organic acids may be used either individually or in combination of two or more.

These organic acids are preferably used in equimolar or less amounts with the above-described amine.

If desired, the positive type resist composition of the present invention may further contain miscible additives, such as additional resins for improving the performance of resist film, surfactants for improving the coatability, anti-dissolving agents, plasticizers, stabilizers, coloring agents, and anti-halation agents.

If necessary, the negative type resist composition of the present invention may further contain a crosslinking agent for the purpose of increasing crosslink density and improving the shape of resist patterns, resolution, and resistance to dry etching.

The crosslinking agent may be any conventional crosslinking agent conventionally used in chemical amplification negative type resists. Examples include aliphatic cyclic hydrocarbons having hydroxyl group or hydroxyalkyl group or both, or oxygen-containing derivatives thereof, such as 2,3-dihydroxy-5-hydroxymethylnorbornane, 2-hydroxy-5,6-bis(hydroxymethyl)norbornane, cyclohexanedimethanol, 3,4,8 (or 9)-trihydroxytricyclodecane, 2-methyl-2-adamantanol, 1,4-dioxane-2,3-diol and 1,3,5-trihydroxycyclohexane; and compounds obtained by reacting formaldehyde, or formaldehyde and lower alcohol, with an amino group-containing compound, such as melamine, acetoguanamine, benzoguanamine, urea, ethylene urea and glycoluril, and substituting the hydrogen atoms of the amino group with hydroxymethyl group or lower alkoxymethyl group, examples being hexamethoxymethylmelamine, bismethoxymethyl urea, bismethoxymethylbismethoxyethylene urea, tetramethoxymethyl glycoluril and tetrabutoxymethyl glycoluril with tetrabutoxymethyl glycoluril being particularly preferred.

These crosslinking agents may be used either individually or in combination of two or more.

Methods of forming resist patterns by liquid immersion lithography using the immersion fluid of the present invention will now be described.

A first method of forming resist pattern in accordance with the present invention using liquid immersion lithography comprises the steps of:
forming at least a photoresist film on a substrate;
directly placing an immersion fluid on the resist film, the immersion fluid comprising a fluorine-based liquid that is transparent to the exposure light used in the liquid immersion lithography and has a boiling point of 70 to 270 °C;
selectively exposing the resist film via the immersion fluid;
optionally heating the resist film; and
developing the resist film to form a resist pattern.

A second method of forming resist pattern in accordance with the present invention using liquid immersion lithography comprises the steps of:
forming at least a photoresist film on a substrate;
forming a protective film on the resist film;
directly placing an immersion fluid on the protective film, the immersion fluid comprising a fluorine-based liquid that is transparent to the exposure light used in the liquid immersion lithography and has a boiling point of 70 to 270 °C;
selectively exposing the resist film via the immersion fluid and the protective film;
optionally heating the resist film; and
developing the resist film to form a resist pattern.

In the first method of forming resist pattern, a commonly available resist composition is first applied to a substrate, such as silicon wafer, by a spinner and then the substrate is prebaked (PAB treatment).

An organic or inorganic anti-reflection film may be disposed between the substrate and the coating layer of the resist composition to form a two-layered laminate.

The above steps can be carried out using known techniques. Conditions for the process are suitably adjusted depending on the composition and properties of the resist composition used.

The resist film formed on the substrate is then exposed to an immersion fluid comprising "a fluorine-based liquid that is transparent to the exposure light used in the liquid immersion lithography and has a boiling point of 70 to 270 °C." While not limited to a particular meaning, the term "exposure" as usedhereinmeans immersing the substrate in the immersion fluid, or directly placing the immersion fluid on the resist film.

The resist film formed on the substrate and immersed in the immersion fluid is then selectively exposed to light via a desired mask pattern. Thus, the exposure light passes through the immersion fluid before it reaches the resist film.

During immersion, the resist film is directly in contact with the immersion fluid. However, the immersion fluid, as described above, is inert to the resist film and does not alter, nor is it altered by, the resist film. The refractive index or other optical characteristics of the immersion film are not affected either. As opposed to room temperature used in the exposure step, the immersion fluid has a boiling point of 70 °C or above, so that the fluid level does not lower and the fluid concentration remains stable. This ensures stable, constant refractive index as well as transparency of the immersion fluid to provide the light path.

The exposure light may be of any wavelength; radiations such as ArF excimer laser, KrF excimer, F₂ laser, extreme ultraviolet (EUV), vacuum ultraviolet (VUV), electron beam, X-ray and soft X-ray may be used. The immersion fluid of the present invention is transparent to any of these wavelengths; light with a suitable wavelength for use is determined depending principally on the characteristics of the resist film.

Once the exposure step carried out in the immersion fluid has been completed, the substrate, for example, is pulled out of the immersion fluid and the immersion fluid is removed from the substrate using such techniques as drying at room temperature, spin drying, heat drying, and nitrogen blowing. Since the boiling point of the immersion fluid is at most 270 °C, the immersion fluid can be completely removed from the resist film using any of the above-described techniques.

Subsequently, the exposed resist film is subjected to post-exposure baking (PEB) and is then developed in an alkaline developing solution comprising an aqueous alkaline solution. The development process may be followed by post baking. The resist film is then rinsed preferably with pure water. The rinsing with water specifically involves dropping or spraying water droplets onto the rotating substrate to rinse off the developing solution, along with the resist composition decomposed by the developing solution and remaining on the substrate. Following this, drying the substrate gives a resist pattern corresponding to the mask pattern.

The second method of forming resist pattern is the same as the first method except that a protective film is disposedbetween the resist film and the immersion fluid.

While the immersion fluid of the present invention serves as a useful tool for extending the use of the liquid immersion lithography to the resists using resins with low liquid immersion resistance, it is also suitable for use in the process to dispose a protective film over the resist film. The coating solution for forming the protective film is preferably an aqueous solution containing a water-soluble or alkali-soluble film forming component.

While the water-soluble film forming component may be any film component that is either water- or alkali-soluble and is transparent to the exposure light, the film component preferably has the following characteristics: i) it can be applied by a common coating technique, such as spin coating, to form a uniform coating film; ii) when applied over the photoresist film, it does not form an altered layer between the photoresist film and the protective film; iii) it can effectively be transparent to active rays; and iv) it can form highly transparent film with small absorption coefficient.

Examples of such a water-soluble film component include cellulose polymers, such as hydroxypropylmethylcellulose phthalate, hydroxypropylmethylcellulose acetate phthalate, hydroxypropylmethylcellulose acetate succinate, hydroxypropylmethylcellulose hexahydrophthalate, hydroxypropylmethylcellulose, hydroxypropylcellulose, hydroxyethylcellulose, cellulose acetate hexahydrophthalate, carboxymethylcellulose, ethylcellulose and methylcellulose; acrylic acid polymers formed of such monomers as N,N-dimethylacrylamide, N,N-dimethylaminopropylmethacrylamide, N,N-dimethylaminopropylacrylamide, N-methylacrylamide, diacetone acrylamide, N,N-dimethylaminoethylmethacrylate, N,N-diethylaminoethylmethacrylate, N,N-dimethylaminoethylacrylate, acryloylmorpholine and acrylic acid; and vinyl polymers, such as polyvinylalcohol and polyvinylpyrrolidone. Among them, acrylic acid polymers and polyvinylpyrrolidone, each a water-soluble polymer that does not bear any hydroxyl groups within its molecule, are preferred. These water-soluble film forming components may be used either individually or in combination of two or more.

Examples of the alkali-soluble film forming component include novolac resins obtained by condensing a phenol (e.g. , phenol, m-cresol, xylenol and trimethylphenol), an aldehyde (e.g., formaldehyde, formaldehyde precursors, propionaldehyde, 2-hydroxybenzaldehyde, 3-hydroxybenzaldehyde and 4-hydroxybenzaldehyde) and/or a ketone (e.g., methyl ethyl ketone and acetone) in the presence of an acidic catalyst; and hydroxystyrene resins, such as homopolymers of hydroxystyrene, copolymers of hydroxystyrene and other styrene monomers, and copolymers of hydroxystyrene and acrylic acid or methacrylic acid or a derivative thereof. These alkali-soluble film forming components may be used either individually or in combination of two or more.

The water-soluble film forming components are preferred to the alkali-soluble film forming components.

The coating solution for forming the protective film may further contain at least one selected from acid-generating agents and acidic compounds. The acid-generating agent may be any known compound used in chemical amplification type resists. Examples include onium salts, such as diphenyliodonium trifluoromethanesulfonate, (4-methoxyphenyl)phenyliodonium trifluoromethanesulfonate, bis(p-tert-butylphenyl)iodonium trifluoromethanesulfonate, triphenylsulfonium trifluoromethanesulfonate, (4-methoxyphenyl)diphenylsulfonium trifluoromethanesulfonate, (4-methylphenyl)diphenylsulfonium trifluoromethanesulfonate, (4-methylphenyl)diphenylsulfonium nonafluorobutanesulfonate, (p-tert-butylphenyl)diphenylsulfonium trifluoromethanesulfonate, diphenyliodonium nonafluorobutanesulfonate, bis(p-tert-butylphenyl)iodonium nonafluorobutanesulfonate, triphenylsulfonium nonafluorobutanesulfonate, (4-trifluoromethylphenyl)diphenylsulfonium trifluoromethanesulfonate, (4-trifluoromethylphenyl)diphenylsulfonium nonafluorobutanesulfonate, and tri(p-tert-butylphenyl)sulfonium trifluoromethanesulfonate.

Examples of the acidic compounds include inorganic acids, such as hydrochloric acid, sulfuric acid, nitric acid and phosphoric acid, and organic acids, such as formic acid, acetic acid, propionic acid, benzenesulfonic acid and toluenesulfonic acid. These organic acids may be used either individually or in combination of two or more.

Among the above-described acidic compounds, preferred are aliphatic carboxylic acids or aliphatic sulfonic acids having 1 to 20 carbon atoms in which some or all of the hydrogen atoms of the saturated or unsaturated hydrocarbon have been substituted with fluorine atoms, and fluorine-substituted sulfonyl compounds.

Examples of the fluorine-substituted carboxylic acid include perfluoroheptanoic acid and perfluorooctanoic acid. Examples of the fluorine-substituted sulfonic acid include perfluoropropylsulfonic acid, perfluorooctylsulfonic acid and perfluorodecylsulfonic acid. Perfluoroheptanoic acid and perfluorooctylsulfonic acid suitable for use in the present invention are sold under the product names of EF-201 and EF-101, respectively (both manufactured by Tochem Products Co., Ltd.).

Examples of the fluorine-substituted sulfonyl compound include tris(trifluoromethylsulfonyl)methane (CF₃SO₂)₃CH, bis(trifluoromethylsulfonyl)amine (CF₃SO₂)₂NH and bis(pentafluoroethylsulfonyl)amine (C₂F₅SO₂)₂NH.

The acidic compound and/or the acid-generating agent serve to improve the shape of the resulting resist patterns as well as the stability of the protective film forming material over time.

The coating solution for forming the protective film is typically used in the form of aqueous solution and preferably contains the water-or alkali-soluble film forming component in an amount of 0.5 to 10.0 wt%. The coating solution preferably contains the acidic compound and/or the acid-generating agent in an amount of 1.0 to 15.0 wt%. The coating solution preferably has an acidic pH while it may have any pH value.

The coating solution for forming the protective film may further contain a nitrogen-containing compound. Examples of the preferred nitrogen-containing compound include quaternary ammonium hydroxides, alkanol amine compound, and amino acid derivatives.

The nitrogen-containing compound serves to adjust the pH of the protective film forming material and, thus, improve the shape of the resulting resist pattern.

The resist patterning carried out in the above-described manner can achieve resist patterns with fine line widths, in particular, line-and-space patterns with small pitches and high resolution. The term "pitch" of the line-and-space patterns as used herein refers to the total of the resist pattern width and the space width.

### Examples

The present invention will now be described with reference to examples, which are intended to be illustrative only and do not limit the scope of the invention in any way. In the description that follows, Examples are presented along with Comparative Examples.

### (Example 1)

In the manner described below, a resin component, an acid-generating agent and a nitrogen-containing organic compound are uniformly dissolved in an organic solvent to form a positive type resist composition 1.

The resin component used was 100 parts by weight of a methacrylate/acrylate copolymer composed of three structural units shown by the following chemical formulae (40a), (40b), and (40c). The structural units p, q, and r to form the resin component were used in proportions of 50 mol %, 30 mol %, and 20 mol %, respectively. The resulting resin component had a weight-average molecular weight of 10000.

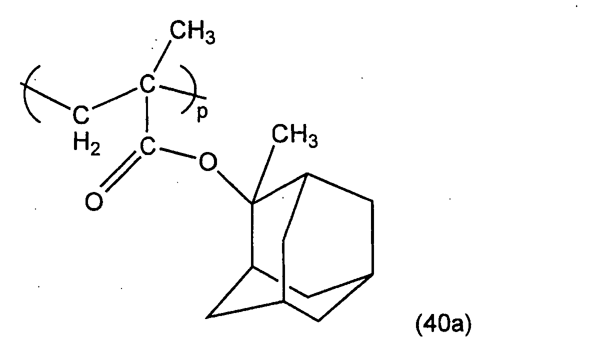

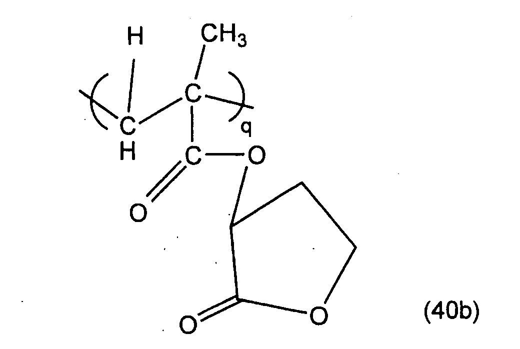

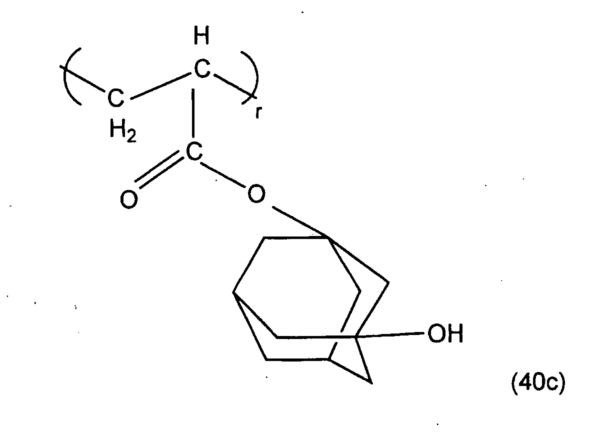

The acid-generating agent used was 3.5 parts by weight of triphenylsulfonium nonafluorobutanesulfonate in combination with 1.0 part by weight of (4-methylphenyl)diphenylsulfonium trifluoromethanesulfonate.

The organic solvent used was 1900 parts by weight of a mixed solvent of propyleneglycol monomethylether acetate with ethyl lactate (6 : 4 by weight ratio).

0.3 parts by weight of triethanolamine was used as the nitrogen-containing organic compound.

The positive type resist composition 1 prepared in this manner was used to form a resist pattern.

First, using a spinner, an organic anti-reflection film composition AR-19 (tradename, manufactured by Shipley Co., Ltd.) was applied to a silicon wafer. The composition was dried by baking the wafer on a hot plate at 215 °C for 60 seconds to form an 82 nm thick organic anti-reflection film. Using a spinner, the positive type resist composition 1 was applied over the anti-reflection film, and the composition was dried by pre-baking the wafer on a hot plate at 115 °C for 90 seconds to form a 150 nm thick resist film over the anti-reflection film.

Perfluoro (2-butyl tetrahydrofuran) with a boiling point of 102 °C was used as the immersion fluid. As the liquid immersion lithography apparatus, an apparatus manufactured by Nikon Co. , Ltd. that operates based on the two-beam interference exposure method was used (Specifically, the apparatus is designed such that the interference light generated by a prism is used as a substitute light beam for the patterning light and is irradiated onto the immersed sample for exposure). Using exposure light with a wavelength of 193 nm (ArF excimer laser), liquid immersion lithography was performed on the resist film. During the process, the bottom surface of the prism, arranged at the lowest part of the apparatus, was in contact with the resist film via the perfluoro(2-butyl tetrahydrofuran) immersion fluid.

Following the exposure, the substrate was spin-dried to completely remove the perfluoro (2-butyl tetrahydrofuran) immersion fluid from the resist film.

Subsequently, the substrate was subjected to PEB at 115 °C for 90 seconds and was then developed in an alkaline developing solution at 23 °C for 60 seconds. The alkaline developing solution used was a 2.38 weight % aqueous solution of tetramethylammonium hydroxide.

The resulting resist pattern having 65 nm line-to-space ratio of 1 : 1 was observed with a scanning electron microscope (SEM). As a result, the pattern profile proved to be of sufficient quality and no defects were observed, including fluctuation phenomenon (partial narrowing of lines). An observation using focused ion-beam SEM (Altura 835, manufactured by FEI Co., Ltd.) revealed that the pattern profile had well-defined edges.

### (Example 2)

The same procedure was followed as in Example 1 to make a resist pattern, except that a photoresist composition 2 as described below was used.

The resin component used was 100 parts by weight of the structural unit shown by the following chemical formula (41). The resulting resin component had a weight-average molecular weight of 10000.

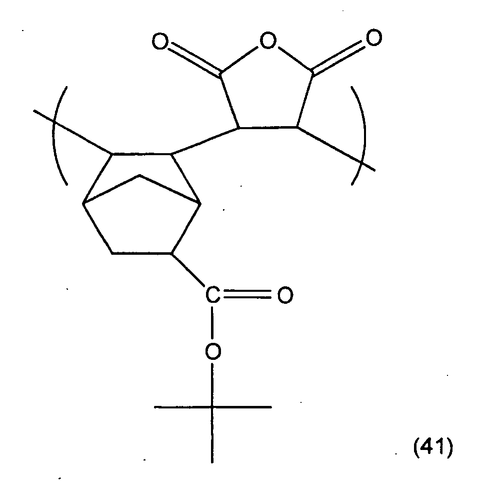

The acid-generating agent used was 3.5 parts by weight of triphenylsulfonium nonafluorobutanesulfonate in combination with 1.0 part by weight of (4-methylphenyl)diphenylsulfonium trifluoromethanesulfonate.

The organic solvent used was 1900 parts by weight of a mixed solvent of propyleneglycol monomethylether acetate with ethyl lactate (6 : 4 by weight ratio).

0.3 parts by weight of triethanolamine was used as the nitrogen-containing organic compound.

The resulting resist film was 140 nm thick and the resist pattern had 90 nm line-to-space ratio of 1 : 1.

Scanning electron microscopy (SEM) of the resulting resist pattern revealed that the pattern profile was of sufficient quality and the resistpatternhadnodefects, including fluctuation phenomenon (partial narrowing of lines).

### (Example 3)

The same procedure was followed as in Example 2 to make a resist pattern with a 90 nm line-to-space ratio of 1 : 1, except that a photoresist composition 3, a negative type resist composition as described below, was used.

The resin component used was 100 parts by weight of a copolymer composed of two structural units shown in the following chemical formula (42). The two structural units were present in the resin component in proportions of m = 84 mol % and n = 16 mol %. The resulting resin component had a weight-average molecular weight of 8700.

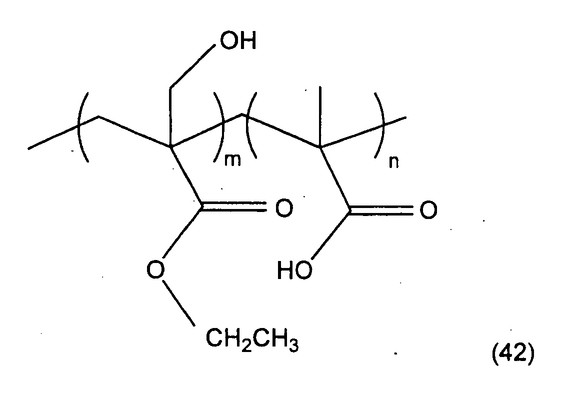

10 weight % (relative to the resin component) of tetrabutoxymethylated glycoluril to serve as the crosslinking agent, along with 1 weight % of triphenylsulfonium nonafluorobutanesulfonate in combination with 0.6 weight % of 4-phenylpyridine to serve as the acid-generating agent, were dissolved in a mixed solvent of propyleneglycolmonomethylether acetate and ethyl lactate to make a composition containing 8.1 weight % of the solid component. The resulting resist film was 220 nm thick. Scanning electron microscopy (SEM) of the resulting resist pattern revealed that the pattern profile was of sufficient quality and the resist pattern had no defects, including fluctuation phenomenon (partial narrowing of lines).

### (Comparative Example 1)

The same procedure was performed as in Example 1 on a similar resist film to make a resist pattern, except that the immersion fluid used was pure water.

The resulting pattern profile showed some degree of fluctuation phenomenon.

### (Comparative Example 2)

The same procedure was performed as in Example 1 on a similar resist film to make a resist pattern, except that the immersion fluid used was a perfluoroalkyl polyether compound (tradename: DEMNUM S-20, DAIKIN Industries, Ltd.), which had an extremely low volatility with a vapor pressure at 200 °C of 10⁻¹ torr.

As a result, the immersion fluid could not be removed even after the resist film was subjected to the spin drying for a sufficient time period following the exposure. Heating and nitrogen blowing, the other fluid-removing techniques, also failed to remove the immersion fluid from the resist film. The remaining perfluoropolyether compound interfered with the formation of resist patterns.

### (Comparative Example 3)

The same procedure was followed as in Example 2 to make a resist pattern with a 90 nm line-to-space ratio of 1 : 1, except that water was used as the medium to fill the space between the bottom surface of the prism and the substrate.

Scanning electron microscopy (SEM) of the resulting resist pattern revealed significant alteration of the resist pattern.

### (Comparative Example 4)

The same procedure was followed as in Example 3 to make a resist pattern with a 90 nm line-to-space ratio of 1 : 1, except that water was used as the medium to fill the space between the bottom surface of the prism and the substrate.

Scanning electron microscopy (SEM) of the resulting resist pattern revealed some degree of fluctuation phenomenon in the pattern profile.

### (Example 4)

A res in component containing repeating units shown by the following chemical formula (43), along with 10 weight % (relative to the resin component) of tetrabutoxymethylated glycoluril to serve as the crosslinking agent, 1.5 weight % of triphenylsulfonium perfluorobutanesulfonate to serve as the acid-generating agent and 0.2 weight % of triethanolamine to serve as the amine component, was dissolved in propyleneglycolmonomethylether to make a negative type resist containing 7.0 weight % of the solid component. 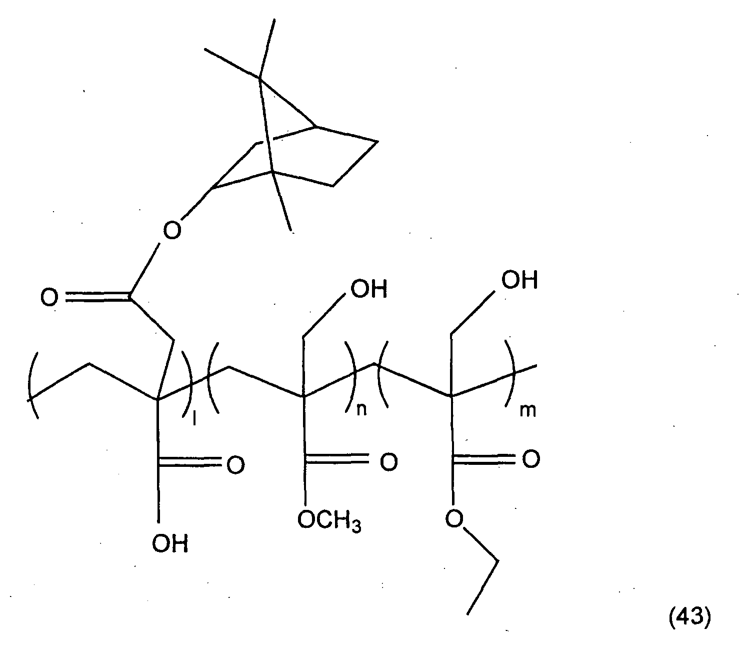 (wherein 1 : m : n = 20 : 40 : 40 (mol %))

Meanwhile, an organic anti-reflection film composition "AR-19" (tradename, manufactured by Shipley Co., Ltd.) was applied to a silicon wafer substrate using a spinner. The composition was dried by baking the substrate on a hot plate at 215°C for 60 seconds to form a 82 nm thick organic anti-reflection film. Using a spinner, the negative type resist was then applied over the anti-reflection film, and the resist was dried by pre-baking the substrate at 140 °C for 60 seconds to form a 150 nm thick resist film over the anti-reflection film.

Subsequently, the substrate was subjected to liquid immersion lithography using a two-beam interference exposure apparatus (manufactured by Nikon Co., Ltd.) (The apparatus operates by irradiating a two-beam interference beam via a prism to simulate the patterning exposure light). Perfluoro(2-butyl tetrahydrofuran) was used as the immersion fluid and ArF excimer laser with a wavelength of 193 nm was used as the light source. During the process, the bottom surface of the prism of the apparatus was in contact with the resist film via perfluoro(2-butyl tetrahydrofuran).

Following the exposure, the substrate was subjected to PEB at 130 °C for 60 seconds and was then developed in an alkaline developing solution at 23 °C for 60 seconds. The alkaline developing solution used was a 2.38 wt % aqueous solution of tetramethylammonium hydroxide.

The resulting resist pattern having a 90nm line-to-space ratio of 1 : 1 was observed with a scanning electron microscope (SEM). As a result, the pattern profile proved to be of sufficient quality with no pattern defects such as swelling.

Similarly, the line edge roughness (LER) was observed with SEM and was determined to be 2.9 nm.

### (Example 5)

The same procedure was followed as in Example 4 to make a resist pattern having a 65nm line-to-space ratio of 1 : 1. Scanning electron microscopy (SEM) of the resist pattern revealed that the pattern profile was of sufficient quality with no pattern defects including swelling.

### (Example 6)

A positive resist was prepared composed of 100 parts by weight of a resin component shown by the following general formula (44) and having a weight-average molecular weight of 10000, 2.5 parts by weight of triphenylsulfonium nonafluorobutanesulfonate in combination with 1.0 part by weight of (4-methylphenyl)diphenylsulfonium trifluoromethanesulfonate to serve as the acid-generating agent, 0.3 parts by weight of triethanolamine, and 1900 parts by weight of a mixed solvent composed of propyleneglycolmonomethylether acetate and ethyl lactate (6 : 4 by weight ratio). 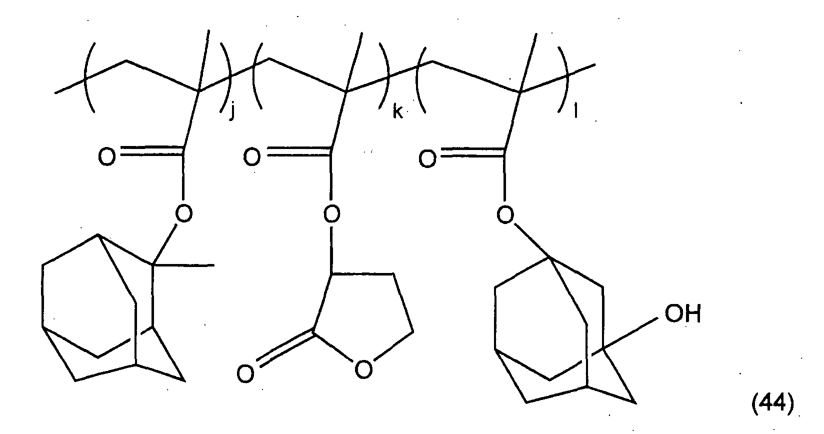 (wherein j : k : l = 50 : 30 : 20 (mol %))

Meanwhile, an organic anti-reflection film composition "AR-19" (tradename, manufactured by Shipley Co. , Ltd.) was applied to a silicon wafer substrate using a spinner. The composition was dried by baking the substrate on a hot plate at 215 °C for 60 seconds to form a 82 nm thick organic anti-reflection film. Using a spinner, the positive resist was then applied over the anti-reflection film, and the resist was dried by pre-baking the substrate at 115 °C for 90 seconds to form a 140 nm thick resist film over the anti-reflection film.

Subsequently, the substrate was subjected to liquid immersion lithography using a two-beam interference exposure apparatus (manufactured by Nikon Co., Ltd.) (The apparatus operates by irradiating a two-beam interference beam via a prism to simulate the patterning exposure light). Perfluoro(2-butyl tetrahydrofuran) was used as the immersion fluid and ArF excimer laser with a wavelength of 193 nm was used as the light source. During the process, the bottom surface of the prism of the apparatus was in contact with the resist film via perfluoro(2-butyl tetrahydrofuran).

Following the exposure, the substrate was subjected to PEB at 115 °C for 90 seconds and was then developed in an alkaline developing solution at 23 °C for 60 seconds. The alkaline developing solution used was a 2.38 wt% aqueous solution of tetramethylammonium hydroxide.

The resulting resist pattern having a 50 nm line-to-space ratio of 1 : 1 was observed with a scanning electron microscope (SEM). As a result, the pattern profile proved to be of sufficient quality with no pattern defects such as swelling.

### (Example 7)

A resist pattern having a 45 nm line-to-space ratio of 1 : 1 was formed in the same manner as in Example 6, except that the resist film was 110 nm thick and the baking prior to exposure was carried out at 125 °C for 90 seconds. Scanning electron microscopy (SEM) revealed that the pattern profile was of sufficient quality with no pattern defects such as swelling.

### (Example 8)

A resist pattern having a 50 nm line-to-space ratio of 1 : 1 was formed in the same manner as in Example 6, except that 5.0 parts by weight of perfluorooctylsulfonic acid was used as the acid-generating agent. Scanning electron microscopy (SEM) revealed that the pattern profile was of sufficient quality with no pattern defects such as swelling.

### (Example 9)

### (Evaluation Test 1 to evaluate a resist using a fluorine polymer)

A resin component, an acid-generating agent and a nitrogen-containing organic compound were dissolved in an organic solvent to form a positive type resist composition F1. The resin component used was 100 parts by weight of a copolymer composed of two structural units shown in the following chemical formulae. The two structural units were present in the resin component in proportions of m = 50 mol % and n = 50 mol %. The resulting resin component had a weight-average molecular weight of 10000. 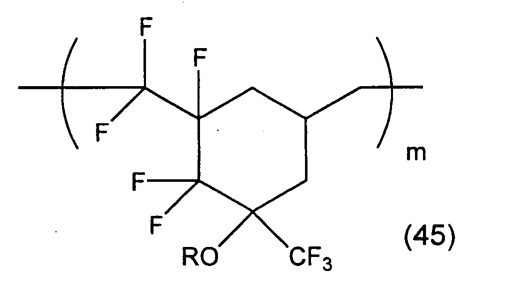 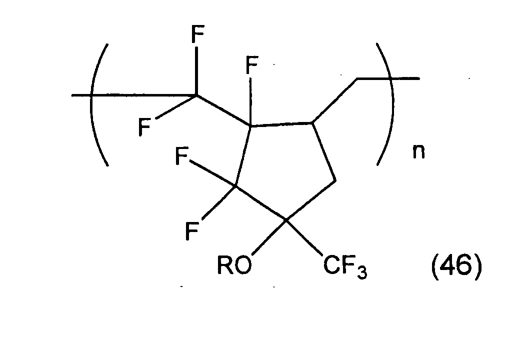 (In the general formulae (45) and (46) above, R is CH₂OCH₃ or H)

The acid-generating agent used was 5.0 parts by weight of triphenylsulfonium perfluorobutanesulfonate.

The organic solvent used was propyleneglycol monomethylether acetate (PGMEA).

The nitrogen containing organic compound used was 0.4 parts by weight of triisopropanolamine in combination with 0.1 parts by weight of salicylic acid.

5 parts by weight of a fluorine compound as shown by the following chemical formula (47) were used as an anti-dissolving agent:

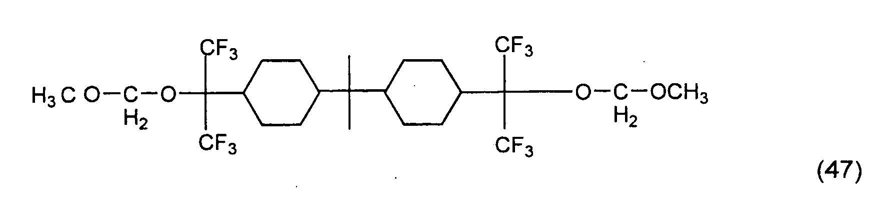

The positive type resist composition F1 prepared in this manner was used to form a resist pattern. First, using a spinner, an organic anti-reflection film composition "AR-19" (tradename, manufactured by Shipley Co., Ltd.) was applied to a silicon wafer. The composition was dried by baking the wafer on a hot plate at 215 °C for 60 seconds to form an 82 nm thick organic anti-reflection film. Using a spinner, the positive type resist composition F1 was applied over the anti-reflection film, and the composition was dried by pre-baking the wafer on a hot plate at 90 °C for 90 seconds to form a 250 nm thick resist film over the anti-reflection film.

Meanwhile, 500g of a 20 wt% aqueous solution of a perfluorooctylsulfonic acid (C₈F₁₇SO₃H, EF-101, manufactured by Tochem Products Co., Ltd.) was mixed with 80g of a 20 wt% aqueous solution of monoethanolamine. 25g of this mixture was added to 20g of a 10 wt% aqueous solution of polyvinylpyrrolidone. To the resulting aqueous solution, pure water was added to form 200g of a coating solution for forming a protective film. The pH of the coating solution was 2.7.

The coating solution was then applied over the resist film and the wafer was spin-dried (dried by rotation) to form a 44 nm thick protective film.

Using a lithography apparatus NSR-302B (NA (numerical aperture) = 0.60, 2/3 orbicular zone, manufactured by Nikon Co., Ltd.) with ArF excimer laser (193 nm), a patterning light was irradiated (exposure). Subsequently, the wafer was subjected to PEB at 120 °C for 90 seconds and was then developed in a 2.38 weight % aqueous solution of tetramethylammonium, serving as the alkaline developing solution, at 23 °C for 60 seconds. The resulting resist pattern having a 130 nm line-to-space ratio of 1 : 1 was observed with a scanning electron microscope (SEM). As a result, the pattern profile proved to be of sufficient quality with no fluctuation or other defects. The exposure sensitivity was 18.55 mJ/cm² (equal to the sensitivity in normal dry process).

During the pattern forming process, liquid immersion lithography was performed in the same manner, except that a fluorine-based liquid comprising perfluoro(2-butyltetrahydrofuran) was added dropwise at 23 °C over a 1-minute period onto the rotating exposed silicon wafer with the resist film formed on it.

In actual production process, the exposure to light is carried out while the resist film is completely immersed in the immersion fluid. In this test, however, the resist film is exposed to light in advance and the fluorine-based liquid (i.e., immersion fluid) having a high refractive index was simply applied to the resist film after the exposure, so that the effect of the immersion fluid on the resist film can be evaluated exclusively. This is supported by the previous analysis of liquid immersion lithography showing that the exposure process itself can be completely carried out with the optical system alone.

The resulting resist pattern having a 130 nm line-to-space ratio of 1 : 1 was observed with a scanning electron microscope (SEM). As a result, the pattern profile proved to be of sufficient quality with no fluctuation or other defects. The exposure sensitivity (the sensitivity in liquid immersion lithography) was 18.54 mJ/cm², which differed from the sensitivity in normal dry process by 0.05%. Thus, the sensitivity in the liquid immersion process showed substantially no difference from the process that did not use the fluorine-based liquid. This indicates that the fluorine-based solvent comprising perfluoro(2-butyltetrahydrofuran) does not significantly affect the resist film in the liquid immersion lithography.

### (Example 10)

Liquid immersion lithography was carried out in the same manner as in Example 9 to form a resist pattern, except that perfluorotripropylamine was used as the immersion fluid in place of perfluoro(2-butyltetrahydrofuran) serving as a fluorine-based liquid.

The resulting resist pattern having a 130 nm line-to-space ratio of 1 : 1 was observed with a scanning electron microscope (SEM). As a result, the pattern profile proved to be of sufficient quality with no fluctuation or other defects. The exposure sensitivity (the sensitivity in liquid immersion lithography) was 19.03 mJ/cm², which differed from the sensitivity in normal dry process by 2.58%. Thus, the sensitivity in the liquid immersion process showed substantially no difference from the process that the fluorine-based liquid was dropped. This indicates that the fluorine-based solvent comprising perfluorotripropylamine does not significantly affect the resist film in the liquid immersion lithography.

### (Example 11)

A positive type resist composition F2, which will be described in Example 13, was applied to a rotating silicon wafer. The wafer was then heated at 90 °C for 90 seconds to form a 150 nm thick resist exposed film. This is referred to as "unexposed film." Meanwhile, the above-described resist coating was exposed to F₂ excimer laser (157 nm) on a contact lithography apparatus VUVES-4500 (manufactured by Lithotech Japan Co. , Ltd.). The laser was irradiated onto an area large enough to visually observe it (approx. 10 mm²). The exposure amount was 40 mJ/cm². The wafer was then subjected to PEB at 120 °C for 90 seconds. The resulting film is referred to as "exposed film."

The unexposed film and the exposed film were each immersed in perfluorotripropylamine, which had a boiling point of 130 °C. While the films were immersed in the liquid, the variation of the thickness of each film was determined by a film thickness analyzer "RDA-QZ3" (manufactured by Lithotech Japan Co., Ltd.) equipped with a quartz crystal microbalance (referred to as "QCM," hereinafter).

### Measurements were taken up to 300 seconds.

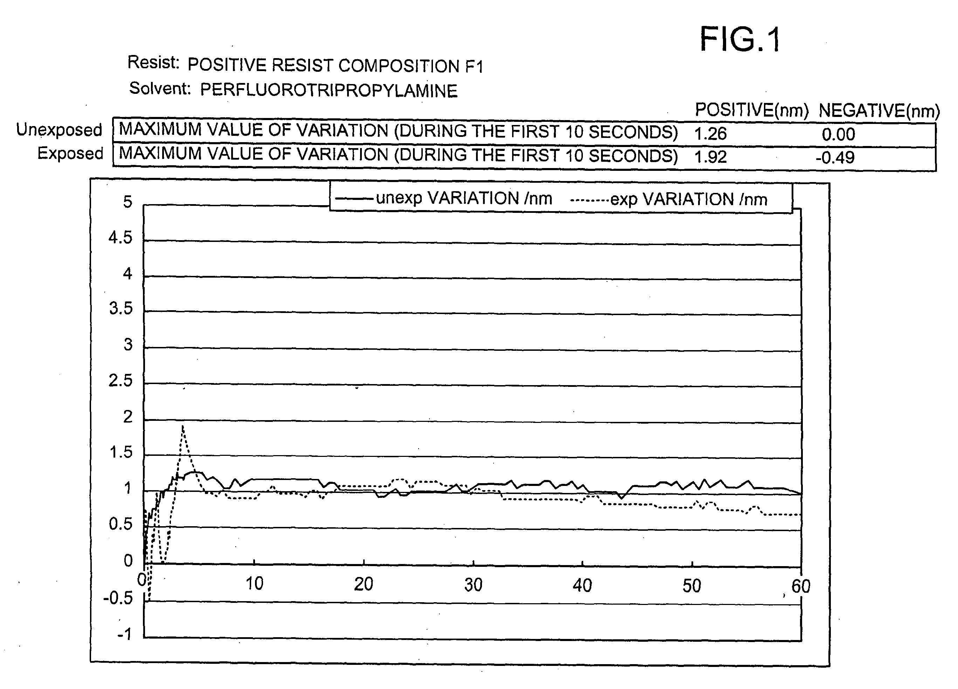

The change in the frequency of the quartz substrate was measured and the data obtained was analyzed by an accompanying analysis software. Based on the analysis, a curve showing the relationship between the immersion time and the film thickness was constructed. The curves of the examples are shown in Fig. 1.

To clearly visualize the difference between the exposed and unexposed film, the variation of the film thickness was in each case plotted again with respect to the thickness difference based on 0 second immersion time. Thus, a film thickness smaller than the initial film thickness has a negative value and a film thickness larger than the initial film thickness has a positive value. For each sample, the positive maximum value and the negative maximum value of the variation of the film thickness were determined. When there was no variation, either positive or negative, the variation was assigned 0 nm.

The maximum increase in the film thickness during the first 10 seconds of the measurement was 1.26 nm for the unexposed film and 1.92 nm for the exposed film. The maximum decrease in the film thickness during the first 10 seconds was 0 nm for the unexposed film and 0.49 nm for the exposed film.

### (Example 12)

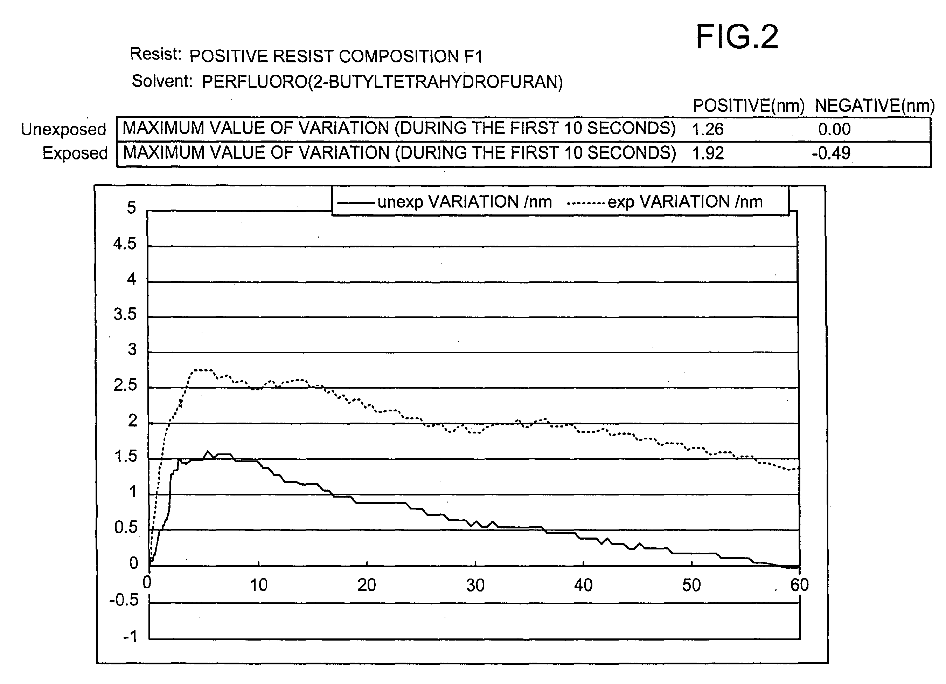

The variation of the thickness of each film was measured in the same manner as in Example 11, except that perfluoro(2-butyltetrahydrofuran) was used in place of perfluorotripropylamine. The curves of the examples are shown in Fig. 2. The maximum increase in the film thickness during the first 10 seconds of the measurement was 1.62 nm for the unexposed film and 2.76 nm for the exposed film. The maximum decrease in the film thickness during the first 10 seconds was 0 nm for the unexposed film and 0 nm for the exposed film.

### (Example 13)

The following components were dissolved in propyleneglycol monomethylether acetate to form a uniform solution containing 8.5 wt% solid component: 100 parts by weight of the resin component used in the positive type resist composition F1 of Example 9 and shown by the general formulae (45) and (46) ; 2.0 parts by weight of triphenylsulfonium nonafluorobutanesulfonate to serve as the acid-generating agent; and 0.6 parts by weight of tridodecylamine to serve as the amine.

The resulting solution was used as a positive type resist composition F2 to form a resist pattern.

First, using a spinner, an organic anti-reflection film composition "AR-19" (tradename, manufactured by Shipley Co. , Ltd.) was applied to a silicon wafer. The composition was dried by baking the wafer on a hot plate at 215 °C for 60 seconds to form an 82 nm thick organic anti-reflection film. Using a spinner, the positive type resist composition F2 was applied over the anti-reflection film, and the composition was dried by pre-baking the wafer on a hot plate at 95 °C for 90 seconds to form a 102 nm thick resist film over the anti-reflection film.

Using an apparatus manufactured by Nikon Co., Ltd, liquid immersion lithography was performed as Evaluation Test 2 (two-beam interference test), which involved a prism and a fluorine-based solvent comprising perfluorotripropylamine and which took advantage of the interference between two 193 nm light beams. Similar technique is disclosed in the aforementioned non-patent article 2 (J.Vac.Sci.Technol.B (2001) 19(6) p2353-2356). The technique can readily achieve a line-and-space pattern at laboratory level.

In the above-described liquid immersion lithography, a layer of the fluorine-based solvent to serve as the immersion medium was disposed between the upper surface of the protective film and the lower surface of the prism.

The amount of the exposure light was selected such that a stable line-and-space pattern could be obtained. Following the exposure via a mask, the fluorine-based liquid was wiped off the wafer and the wafer was subjected to PEB at 115 °C for 90 seconds.

Subsequently, the resist was developed in a 2.38 weight % aqueous solution of tetramethylammonium hydroxide at 23 °C for 60 seconds.

As a result, a 65nm line-and-space (1:1) was obtained. The sensitivity of the resist was 11.3 mJ/cm². The pattern profile was somewhat T-shaped but was of sufficient quality.

### (Example 14)

A resist pattern was formed in a two-beam interference test in the same manner as in Example 13, except that the coating solution, used to form the protective film in Example 9, was applied between the resist film and the fluorine-based solvent and was dried by heating at 95 °C for 60 seconds to form a 35 nm thick protective film.

As a result, a 90 nm line-and-space (1:1) was obtained. The sensitivity of the resist was 10.4 mJ/cm². The pattern profile had well-defined rectangle edges and was of sufficient quality.

### (Example 15)

A resist pattern was formed in a two-beam interference test in the same manner as in Example 13, except that the resist film was 125 nm thick, rather than 102 nm, and the coating solution used to form the protective film in Example 9 was applied between the resist film and the fluorine-based solvent and was dried by heating at 95 °C for 60 seconds to form a 35 nm thick protective film.

As a result, a 65 nm line-and-space (1:1) was obtained. The sensitivity of the resist was 7.3 mJ/cm². The pattern profile had well-defined rectangle edges and was of excellent quality.

### (Example 16)

A resist pattern was formed in a two-beam interference test in the same manner as in Example 13, except that the positive type resist composition 1 used in Example 1 was used in place of the positive type resist composition F2; pre-baking was carried out at 125 °C; the resist film formed was 95 nm thick; and the coating solution used to form the protective film in Example 9 was applied between the resist film and the fluorine-based liquid and was dried by heating at 95 ° C for 60 seconds to form a 35 nm thick protective film.

As a result, a 90 nm line-and-space (1:1) was obtained. The sensitivity of the resist was 14.8 mJ/cm². The pattern profile had well-defined rectangle edges and was of sufficient quality.

### (Example 17)

A resist pattern was formed in a two-beam interference test in the same manner as in Example 1, except that perfluorotributylamine having a boiling point of 174 °C was used in place of the perfluoro(2-butyltetrahydrofuran) immersion fluid used in Example 1.

The resulting resist pattern having a 65 nm line-to-space ratio of 1 : 1 was observed with a scanning electron microscope (SEM). As a result, the pattern profile proved to be of sufficient quality with no fluctuation phenomenon (partial narrowing of lines) or other defects. A further observation of the pattern profile using a focused ion beam SEM (Altra 835, manufactured by FEI Company) revealed that the profile had well-defined rectangle edges and was of sufficient quality.

### (Example 18)

A resist pattern was formed in a two-beam interference test in the same manner as in Example 1, except that perfluorotripentylamine having a boiling point of 215 °C was used in place of the perfluoro(2-butyltetrahydrofuran) immersion fluid used in Example 1.

The resulting resist pattern having a 65 nm line-to-space ratio of 1 : 1 was observed with a scanning electron microscope (SEM). As a result, the pattern profile proved to be of sufficient quality with no fluctuation phenomenon (partial narrowing of lines) or other defects. A further observation of the pattern profile using a focused ion beam SEM (Altra 835, manufactured by FEI Company) revealed that the profile had well-defined rectangle edges and was of sufficient quality.

### INDUSTRIAL APPLICABILITY

As set forth, the immersion fluid of the present invention for use in liquid immersion lithography can be used in liquid immersion lithography to formprecision resist patterns that are highly sensitive, and have a superb resist pattern profile. In particular, the immersion fluid can be used in liquid immersion lithography with any of conventional resist compositions to form resist patterns that do not have defects such as surface roughness, including T-shaped top profile, pattern fluctuation and string formation phenomenon.

The method of forming resist pattern using the immersion fluid for liquid immersion lithography in accordance with the present invention allows the production of superb resist patterns whether the immersion fluid is directly placed on the resist film or the immersion fluid is placed on a protective film deposited on the resist film.

### (References)

1. Journal of Vacuum Science & Technology B (J. Vac. Sci. Technol. B) vol.17 No.6 (1999): pp. 3306-3309, USA
2. Journal of Vacuum Science & Technology B (J.'Vac. Sci. Technol. B) vol.19 No.6 (2001): pp. 2353-2356, USA
3. Proceedings of SPIE Vol. 4691 (2002): pp. 459-465, USA

## Claims

1. An immersion fluid for use in liquid immersion lithography in which a resist film is exposed to light via a fluid, the immersion fluid being transparent to exposure light used in the liquid immersion lithography and comprising a fluorine-based liquid having a boiling point of 70 to 270 °C.

2. The immersion fluid for use in liquid immersion lithography according to claim 1, wherein the liquid immersion lithography is such that a predetermined thickness of the immersion fluid, having a higher refractive index than that of air, is placed in a path of the lithography exposure light and at least on the resist film, so as to improve the resolution of the exposed resist pattern.

3. The immersion fluid for use in liquid immersion lithography according to claim 1, wherein the fluorine-based liquid has a boiling point of 80 to 220 °C.

4. The immersion fluid for use in liquid immersion lithography according to claim 1, wherein the fluorine-based liquid is a perfluoroalkyl compound.

5. The immersion fluid for use in liquid immersion lithography according to claim 4, wherein the perfluoroalkyl compound is a perfluoroalkyl ether compound.

6. The immersion fluid for use in liquid immersion lithography according to claim 4, wherein the perfluoroalkyl compound is a perfluoroalkyl amine compound.

7. The immersion fluid for use in liquid immersion lithography according to claim 1, wherein a base polymer of a resist composition for forming the resist film is a polymer comprising a (meth)acrylate unit.

8. The immersion fluid for use in liquid immersion lithography according to claim 1, wherein a base polymer of a resist composition for forming the resist film is a polymer having a structural unit containing an acid anhydride of dicarboxylic acid.

9. The immersion fluid for use in liquid immersion lithography according to claim 1, wherein a base polymer of a resist composition for forming the resist film is a polymer having a structural unit containing a phenolic hydroxyl group.

10. The immersion fluid for use in liquid immersion lithography according to claim 1, wherein a base polymer of a resist composition for forming the resist film is a silsesquioxane resin.

11. The immersion fluid for use in liquid immersion lithography according to claim 1, wherein a base polymer of a resist composition for forming the resist film is a polymer having an a- (hydroxyalkyl)acrylic acid unit.

12. The immersion fluid for use in liquid immersion lithography according to claim 1, wherein a base polymer of a resist composition for forming the resist film is a polymer having a dicarboxylic acid monoester unit.

13. The immersion fluid for use in liquid immersion lithography according to claim 1, wherein a base polymer of a resist composition for forming the resist film is a fluorine-containing polymer.

14. The immersion fluid for use in liquid immersion lithography according to claim 13, wherein the base polymer of the resist composition for forming the resist film is a fluorine-containing polymer comprising an alkali-soluble structural unit containing an aliphatic cyclic group that has both of (i) fluorine atom or fluorinated alkyl group and (ii) alcoholic hydroxyl group, and the solubility of the polymer in an alkali solution changes when the polymer is acted upon by an acid.

15. A method of forming resist pattern using liquid immersion lithography, comprising the steps of:
forming at least a photoresist film on a substrate;
directly placing an immersion fluid on the resist film, the immersion fluid comprising a fluorine-based liquid being transparent to exposure light used in the liquid immersion lithography and having a boiling point of 70 to 270 °C;
selectively exposing the resist film via the immersion fluid;
optionally heating the resist film; and
developing the resist film to form a resist pattern.

16. A method of forming resist pattern using liquid immersion lithography, comprising the steps of:
forming at least a photoresist film on a substrate;
forming a protective film on the resist film;
directly placing an immersion fluid on the protective film, the immersion fluid comprising a fluorine-based liquid being transparent to exposure light used in the liquid immersion lithography and having a boiling point of 70 to 270 °C;
selectively exposing the resist film via the immersion fluid and the protective film;
optionally heating the resist film; and
developing the resist film to form a resist pattern.

17. The method of forming resist pattern according to claim 15 or 16, wherein the fluorine-based liquid has a boiling point of 80 to 220 °C.

18. The method of forming resist pattern according to claim 15 or 16, wherein the fluorine-based liquid is a perfluoroalkyl compound.

19. The method of forming resist pattern according to claim 18, wherein the perfluoroalkyl compound is a perfluoroalkyl ether compound.

20. The method of forming resist pattern according to claim 18, wherein the perfluoroalkyl compound is a perfluoroalkyl amine compound.

21. The method of forming resist pattern according to claim 15 or 16, wherein a base polymer of a resist composition for forming the resist film is a fluorine-containing polymer.

22. The method of forming resist pattern according to claim 21, wherein the base polymer of the resist composition for forming the resist film is a fluorine-containing polymer comprising an alkali-soluble structural unit (a1) containing an aliphatic cyclic group that has both of (i) fluorine atom or fluorinated alkyl group and (ii) alcoholic hydroxyl group, and the solubility of the polymer in an alkali solution changes when the polymer is acted upon by an acid.
